# EUROPEAN PATENT APPLICATION

(11) **EP 4 844 335 A1**
(43) Date of publication of application: **25.11.2026**
(21) Application number: 24925620.7
(22) Date of filing: 10.12.2024
(51) Int. Cl.: G01B 11/26, B81B 7/02

(54) **ANGLE MEASUREMENT APPARATUS AND LIDAR SCANNING SYSTEM**

(30) Priority: 19.02.2024 CN 202410186834
(71) Applicant: Huawei Technologies Co., Ltd., Shenzhen, Guangdong 518129 (CN)
(72) Inventor: WU, Jiahao, Shenzhen, Guangdong 518129 (CN); ZHAO, Fei, Shenzhen, Guangdong 518129 (CN); ZHOU, Wu, Chengdu, Sichuan 611731 (CN)
(74) Representative: MERH-IP Matias Erny Reichl Hoffmann Patentanwälte PartG mbB
(86) International application number: PCT/CN2024/138196
(87) International publication number: WO 2025/175882

(57) **Abstract**

An angle measurement apparatus (200) and a lidar scanning system are provided. The angle measurement apparatus (200) is configured to measure tilt angles of a MEMS micromirror relative to a first rotational axis and a second rotational axis. The angle measurement apparatus (200) includes: a light source (211); and a photoelectric detector matrix (212), including N photoelectric detector arrays (2121), where the photoelectric detector matrix (212) and the light source (211) are located on a same plane, N is greater than or equal to 4, and the light source (211) is located at a central position of the photoelectric detector matrix (212). The angle measurement apparatus (200) can measure the tilt angles of the MEMS micromirror relative to the two axes, and can measure distribution of light spots of a reflected laser by using a measurement array including a plurality of photoelectric detectors, so that response time of a sensor can be accelerated, to implement real-time measurement on an angle change of the MEMS micromirror. In addition, the photoelectric detectors are arranged in a matrix form, achieving a compact arrangement of an overall structure with small occupied space, so that the apparatus is more easily disposed in the lidar scanning system, and can directly measure angles of the MEMS micromirror.

## Description

This application claims priority to Chinese Patent Application No. 202410186834.X, filed with the China National Intellectual Property Administration on February 19, 2024 and entitled "ANGLE MEASUREMENT APPARATUS AND LIDAR SCANNING SYSTEM", which is incorporated herein by reference in its entirety.

### TECHNICAL FIELD

This application relates to the field of optical detection, and in particular, to an angle measurement apparatus and a lidar scanning system.

### BACKGROUND

With the development of self-driving technologies, as an important device of the self-driving technologies, lidars can detect a driving environment. Micro-electro-mechanical system (micro-electro-mechanical system, MEMS) micromirrors feature small size, low power consumption, fast response, and long service life, and therefore are widely used in lidars. To accurately control the MEMS micromirror, tilt angles of the MEMS micromirror need to be measured. However, errors of measurement performed by an angle measurement device based on a piezoresistive feedback and a piezoelectric feedback are large. As a result, it is difficult to accurately measure the tilt angles of the MEMS micromirror. Therefore, how to accurately measure the tilt angles of the MEMS micromirror in real time is an urgent problem to be resolved currently.

### SUMMARY

Embodiments of this application provide an angle measurement apparatus and a lidar scanning system, so that an action of measuring tilt angles of a MEMS micromirror relative to two axes can be decoupled, thereby helping avoid measurement errors caused by coupling of the MEMS micromirror relative to the two axes, improving accuracy of measurement on the tilt angles of the MEMS micromirror, and further eliminating errors caused by temperature drift of the measurement apparatus.

According to a first aspect, an angle measurement apparatus is provided. The angle measurement apparatus is configured to measure tilt angles of a micro-electro-mechanical system MEMS micromirror relative to a first rotational axis and a second rotational axis. The apparatus includes: a light source; and a photoelectric detector matrix, including N photoelectric detector arrays, where the photoelectric detector matrix and the light source are located on a same plane, N is greater than or equal to 4, and the light source is located at a central position of the photoelectric detector matrix.

For example, the first rotational axis may be a fast axis of the MEMS micromirror, and the second rotational axis may be a slow axis of the MEMS micromirror. Generally, the fast axis and the slow axis of the MEMS micromirror intersect and are perpendicular to each other, so that the MEMS micromirror can implement two-dimensional rotation in a horizontal direction and a vertical direction, thereby implementing a two-dimensional laser scanning function of a lidar.

Based on the foregoing technical solution, the tilt angles of the MEMS micromirror relative to the two axes can be measured, and distribution of light spots of a reflected laser can be measured by using a measurement array including a plurality of photoelectric detectors, so that response time of a sensor can be accelerated, to implement real-time measurement on an angle change of the MEMS micromirror. In addition, the photoelectric detectors are arranged in a matrix form, achieving a compact arrangement of an overall structure with small occupied space, so that the apparatus is more easily disposed in a lidar scanning system, and can directly measure angles of the MEMS micromirror.

With reference to the first aspect, in some implementations of the first aspect, the photoelectric detector array includes four photoelectric detectors in a 2×2 arrangement, and the N photoelectric detector arrays are separately located around the light source.

For example, each photoelectric detector array may include four photoelectric detectors in a 2×2 (a quantity of rows×a quantity of columns) arrangement.

For example, the photoelectric detector matrix may alternatively include eight photoelectric detector arrays. Correspondingly, the eight photoelectric detector arrays may be in a 2×4 arrangement.

Based on the foregoing technical solution, distribution of light spots of a reflected laser is measured by using a measurement array including a plurality of photoelectric detectors, so that response time of a sensor can be accelerated, to implement real-time measurement on an angle change of the MEMS micromirror.

With reference to the first aspect, in some implementations of the first aspect, the light source is configured to emit a light beam to a first surface of the MEMS micromirror, the first surface of the MEMS micromirror is coated with a reflective layer, and the MEMS micromirror is configured to reflect the light beam to the photoelectric detector matrix.

Based on the foregoing technical solution, the reflective layer is formed on the first surface of the MEMS micromirror through a coating process, so that a loss of reflected light can be greatly reduce. This helps increase an amplitude of light intensity received by the photoelectric detector matrix, thereby helping improve angular resolution of the apparatus 200.

With reference to the first aspect, in some implementations of the first aspect, the light source and the photoelectric detector matrix are located on a same silicon substrate.

For example, a pad 213 is further provided on the silicon substrate 214. The pad 213 is configured to achieve electrical connection and power supply for the photoelectric detector matrix 212 and electronic components such as the light source 211.

Based on the foregoing technical solution, the light source and the photoelectric detector matrix are disposed on the same silicon substrate, to form an angle measurement apparatus with high integration. In addition, other elements, such as a pad, a mark, and a lead, are further conveniently provided on the silicon substrate, to further increase integration of the apparatus.

With reference to the first aspect, in some implementations of the first aspect, the apparatus further includes a grating cover, the grating cover includes N grating arrays, the grating cover is disposed on the photoelectric detector matrix, positions of the N grating arrays are in one-to-one correspondence with positions of the N photoelectric detector arrays, a stripe direction of a first part of gratings in the N grating arrays is a first direction, a stripe direction of a second part of gratings in the N grating arrays is a second direction, the first direction is parallel to the first rotational axis of the MEMS micromirror, and the second direction is parallel to the second rotational axis of the MEMS micromirror.

It should be understood that, because the positions of the N grating arrays are in one-to-one correspondence with the positions of the N photoelectric detector arrays, strength of optical signals received by the N photoelectric detector arrays is also affected by the N grating arrays. To be specific, sensitivity of a part of photoelectric detectors (for example, a photoelectric detector corresponding to the first part of gratings) in measuring a change of distribution of light spots in the second direction is reduced, and sensitivity of another part of photoelectric detectors (for example, a photoelectric detector corresponding to the second part of gratings) in measuring a change of distribution of laser light spots in the first direction is also reduced.

Based on the foregoing technical solution, even if the MEMS micromirror tilts relative to both the first rotational axis and the second rotational axis, under impact of the grating cover on the light spots, a part of photoelectric detectors in the photoelectric detector matrix can be dedicated to measuring a tilt angle of the MEMS micromirror relative to the first rotational axis, and another part of photoelectric detectors can be dedicated to measuring a tilt angle of the MEMS micromirror relative to the second rotational axis, thereby helping decouple an action of measuring the tilt angles of the MEMS micromirror relative to the two axes.

With reference to the first aspect, in some implementations of the first aspect, the grating cover further includes a lens, a position of the lens corresponds to a position of the light source, and the lens is configured to enable distribution of light spots formed by the light beam emitted by the light source to correspond to stripe directions and stripe shapes of the N grating arrays in the grating cover.

Based on the foregoing technical solution, the lens enables stripe directions of light spots formed on the photoelectric detector matrix to correspond to the stripe directions of the grating arrays, so that the light spots also include stripe spots parallel to the first direction and stripe spots parallel to the second direction. As the MEMS micromirror tilts relative to the two axes, distribution of the stripe spots parallel to the first direction changes only when a deflection amount of the MEMS micromirror relative to the second rotational axis exists in a deflection process, and distribution of the light spot parallel to the second direction changes only when a deflection amount of the MEMS micromirror relative to the first rotational axis exists in the deflection process, to avoid measurements errors caused by coupling of the MEMS micromirror relative to the two axes, and improve accuracy of measurement on the tilt angles of the MEMS micromirror.

With reference to the first aspect, in some implementations of the first aspect, a first spacing exists between a first grating in the first part of gratings and a second grating adjacent to the first grating in the second direction, a stripe of the first grating and a stripe of a third grating adjacent to the first grating in the first direction are staggered by a second spacing in the second direction, the first spacing exists between a fourth grating in the second part of gratings and a fifth grating adjacent to the fourth grating in the first direction, a stripe of the fourth grating and a stripe of a sixth grating adjacent to the fourth grating in the second direction are staggered by the second spacing in the first direction, the first spacing is (n+(1/4))d or (n+(1/2))d, the second spacing is m×d, n and m are integers, and d is a stripe width of the grating.

For example, because there is a specific spacing between gratings, when photoelectric detectors corresponding to these gratings receive light spots that periodically shift with periodic rotation of the MEMS micromirror, a specific phase difference exists in a signal output of these photoelectric detectors in a same time period.

For example, it is assumed that the photoelectric detectors have temperature drift errors. Therefore, output signals of photoelectric detectors corresponding to the first grating and the third grating in a same time period have temperature drift errors. In this case, difference processing is performed on results of the two output signals, and an obtained new output signal result is a result in which the temperature drift errors are eliminated.

Based on the foregoing technical solution, a specific design of the grating cover is used, so that a distribution shape of light spots corresponding to an emitted laser corresponds to distribution of the gratings in the grating cover, and a phase difference exists between outputs of photoelectric sensors of the photoelectric detector array. Based on the phase difference between the outputs of the photoelectric sensors, a corresponding calculation operation can be performed on an output result of each photoelectric sensor, to eliminate error impact of the angle measurement apparatus caused by temperature drift. In addition, because the gratings partially block the light signals, the light spots processed by the grating cover have more light spot characteristics, thereby helping make an output characteristic of the photoelectric detector matrix more distinct. The tilt angles of the MEMS micromirror can be obtained based on the output characteristic.

With reference to the first aspect, in some implementations of the first aspect, a light shielding portion is provided on a side surface of the lens, and the light shielding portion is configured to shield interference light incident from the side surface of the lens.

For example, the interference light may be ambient light. The ambient light includes a light beam from another light source, or a light beam from inside the lidar system. For example, a laser emitted by the lidar is left in the lidar system due to optical module errors and is not emitted, so that the laser is received by the detector in a form of interference light inside the lidar.

Based on the foregoing technical solution, ambient light from a lateral direction can be shielded through the light shielding portion, thereby reducing measurement errors.

With reference to the first aspect, in some implementations of the first aspect, the photoelectric detector matrix is configured to: collect light beams reflected by the MEMS micromirror; and output N collection results, where mapping relationships exist between the N collection results and the tilt angles of the MEMS micromirror.

For example, the foregoing mapping relationships may be expressed in a form of a mathematical formula, or may be represented in a form of a mapping table.

Based on the foregoing technical solution, the tilt angles of the MEMS micromirror can be determined based on an output of the photoelectric detector matrix.

With reference to the first aspect, in some implementations of the first aspect, the light source is a vertical cavity surface emitting laser (vertical cavity surface emitting laser, VCSEL) or a light emitting diode (light emitting diode, LED), and the photoelectric detector is a photo diode (photo diode, PD).

Based on the foregoing technical solution, using LCSEL as the light source can reduce impact of a temperature on light emitting performance of the light source, and using the PD as the photoelectric detector can improve data collection efficiency of the photoelectric detector matrix based on a characteristic of fast response of the PD.

According to a second aspect, a lidar scanning system is provided. The system includes: a micro-electro-mechanical system MEMS micromirror apparatus, including a MEMS micromirror, a first rotational axis, and a second rotational axis, where the MEMS micromirror tilts relative to the first rotational axis and the second rotational axis; and the angle measurement apparatus is disposed below the MEMS micromirror apparatus and faces a first surface of the MEMS micromirror. The angle measurement apparatus includes: a light source; and a photoelectric detector matrix, where the photoelectric detector matrix includes N photoelectric detector arrays, the photoelectric detector matrix and the light source are located on a same plane, N is greater than or equal to 4, and the light source is located at a central position of the photoelectric detector matrix.

With reference to the second aspect, in some implementations of the second aspect, the photoelectric detector array includes four photoelectric detectors in a 2×2 arrangement, and the N photoelectric detector arrays are separately located around the light source.

With reference to the second aspect, in some implementations of the second aspect, the light source is configured to emit a light beam to a first surface of the MEMS micromirror, the first surface of the MEMS micromirror is coated with a reflective layer, and the MEMS micromirror is configured to reflect the light beam to the photoelectric detector matrix.

With reference to the second aspect, in some implementations of the second aspect, the light source and the photoelectric detector matrix are located on a same silicon substrate.

With reference to the second aspect, in some implementations of the second aspect, the angle measurement apparatus further includes a grating cover, the grating cover includes N grating arrays, the grating cover is disposed on the photoelectric detector matrix, positions of the N grating arrays are in one-to-one correspondence with positions of the N photoelectric detector arrays, a stripe direction of a first part of gratings in the N grating arrays is a first direction, a stripe direction of a second part of gratings in the N grating arrays is a second direction, the first direction is parallel to the first rotational axis of the MEMS micromirror, and the second direction is parallel to the second rotational axis of the MEMS micromirror.

With reference to the second aspect, in some implementations of the second aspect, the grating cover further includes a lens, a position of the lens corresponds to a position of the light source, and the lens is configured to enable distribution of light spots formed by the light beam emitted by the light source to correspond to stripe directions and stripe shapes of the N grating arrays in the grating cover.

With reference to the second aspect, in some implementations of the second aspect, a first spacing exists between a first grating in the first part of gratings and a second grating adjacent to the first grating in the second direction, a stripe of the first grating and a stripe of a third grating adjacent to the first grating in the first direction are staggered by a second spacing in the second direction, the first spacing exists between a fourth grating in the second part of gratings and a fifth grating adjacent to the fourth grating in the first direction, a stripe of the fourth grating and a stripe of a sixth grating adjacent to the fourth grating in the second direction are staggered by the second spacing in the first direction, the first spacing is (n+(1/4))d or (n+(1/2))d, the second spacing is m×d, n and m are integers, and d is a stripe width of the grating.

With reference to the second aspect, in some implementations of the second aspect, a light shielding portion is provided on a side surface of the lens, and the light shielding portion is configured to shield interference light incident from the side surface of the lens.

With reference to the second aspect, in some implementations of the second aspect, the photoelectric detector matrix is configured to: collect light beams reflected by the MEMS micromirror; and output N collection results, where mapping relationships exist between the N collection results and the tilt angles of the MEMS micromirror.

With reference to the second aspect, in some implementations of the second aspect, the light source is a vertical cavity surface emitting laser VCSEL or a light emitting diode LED, and the photoelectric detector is a photo diode PD.

With reference to the second aspect, in some implementations of the second aspect, the system further includes: a drive apparatus, disposed below the angle measurement apparatus, where the drive apparatus is configured to drive the MEMS micromirror to tilt relative to the first rotational axis and the second rotational axis; and a support apparatus, configured to support the MEMS micromirror apparatus, the angle measurement apparatus, and the drive apparatus.

According to a third aspect, a vehicle is provided. The vehicle includes the lidar scanning system according to any one of the possible implementations of the second aspect, or the lidar scanning system of the vehicle includes the angle measurement apparatus according to any one of the possible implementations of the first aspect.

### BRIEF DESCRIPTION OF DRAWINGS

FIG. 1 is a functional block diagram of a vehicle 100 according to an embodiment of this application;
FIG. 2 is a diagram of an angle measurement apparatus 200 according to an embodiment of this application;
FIG. 3 is a diagram of an optical lens group 215 according to an embodiment of this application;
FIG. 4 is a diagram of an optical lens group 215 according to an embodiment of this application;
FIG. 5 is a diagram of an angle measurement principle of an apparatus 200 according to an embodiment of this application;
FIG. 6 is a design diagram of a silicon substrate 214 according to an embodiment of this application;
FIG. 7a and FIG. 7b are design diagrams of a PCB according to an embodiment of this application;
FIG. 8 is a diagram of an angle measurement apparatus 300 according to an embodiment of this application;
FIG. 9 is a diagram of a grating cover 270 according to an embodiment of this application;
FIG. 10a and FIG. 10b are diagrams of laser emission and reception based on a grating cover 270 according to an embodiment of this application;
FIG. 11 is a diagram of stripe-shaped light spots formed by an effect of a lens light shielding portion according to an embodiment of this application;
FIG. 12 is a diagram of distribution of grating strips according to an embodiment of this application;
FIG. 13 is a diagram of distribution of light spots on a surface of a PD within a MEMS micromirror rotation period according to an embodiment of this application;
FIG. 14 is a diagram of an output signal of a PD according to an embodiment of this application;
FIG. 15 shows sine wave signals PD1-3 and PD2-4 and square wave signals PD1-3 and PD2-4 according to an embodiment of this application;
FIG. 16a, FIG. 16b, FIG. 16c, and FIG. 16d are diagrams of simulation experiment results output by a photoelectric detector matrix according to an embodiment of this application;
FIG. 17 is a diagram of a simulation experiment result of an intensity change of light spots on a surface of a photoelectric detector matrix according to an embodiment of this application;
FIG. 18 is a schematic flowchart of a calibration parameter determining method 1800 according to an embodiment of this application;
FIG. 19 is a schematic flowchart of a calibration parameter-based angle solving method 1900 according to an embodiment of this application;
FIG. 20 is a diagram of an integrated angle measurement apparatus according to an embodiment of this application;
FIG. 21 is a diagram of a lidar scanning system 2100 according to an embodiment of this application;
FIG. 22a and FIG. 22b are diagrams of a MEMS micromirror apparatus 10 according to an embodiment of this application; and
FIG. 23 is a diagram of a structure of a drive apparatus 30 according to an embodiment of this application.

### DESCRIPTION OF EMBODIMENTS

The following describes technical solutions of embodiments of this application with reference to the accompanying drawings.

In descriptions of embodiments of this application, unless otherwise specified, "/" means "or". For example, A/B may indicate A or B. In this specification, "and/or" describes an association relationship between associated objects and indicates that three relationships may exist. For example, A and/or B may indicate the following three cases: Only A exists, both A and B exist, and only B exists. In this application, at least one means one or more, and a plurality of means two or more. "At least one of the following items (pieces)" or a similar expression thereof indicates any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural.

In embodiments of this application, prefix words such as "first" and "second" are merely intended to distinguish between different described objects, and impose no limitation on locations, sequences, priorities, quantities, content, or the like of the described objects. In embodiments of this application, use of a prefix word, for example, an ordinal number, used for distinguishing between described objects does not constitute a limitation on the described objects. For descriptions of the described objects, refer to the descriptions of the context in the claims or embodiments. The use of such a prefix word should not constitute a redundant limitation.

The following describes technical solutions of embodiments of this application with reference to the accompanying drawings.

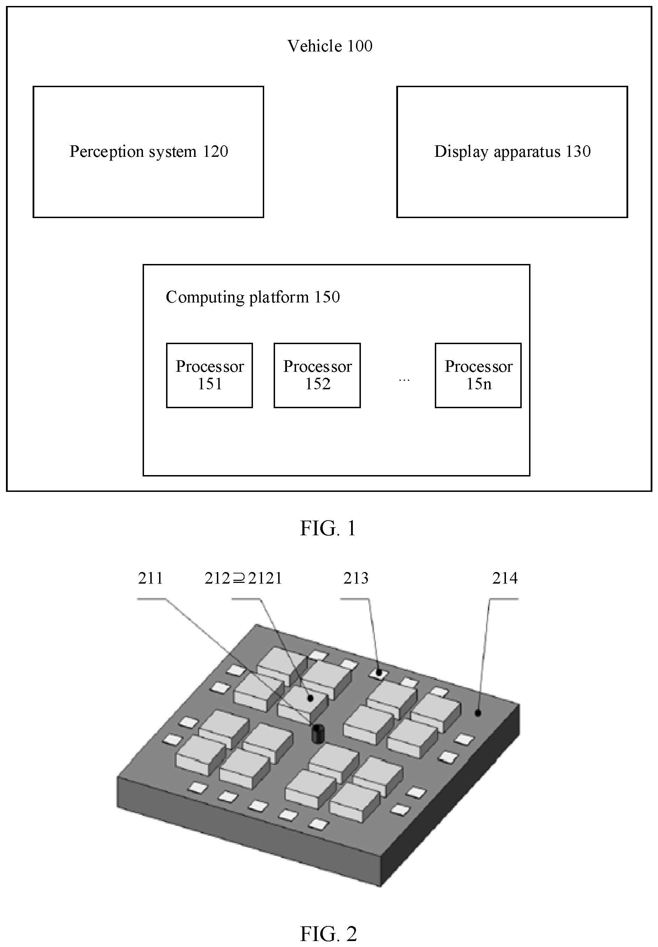

FIG. 1 is a functional block diagram of a vehicle 100 according to an embodiment of this application.

The vehicle 100 may include a perception system 120, a display apparatus 130, and a computing platform 150. The perception system 120 may include several types of sensors that sense information about an environment around the vehicle 100. For example, the perception system 120 may include a positioning system. The positioning system may be a global positioning system (global positioning system, GPS), or may be one or more of a BeiDou system or another positioning system, an inertial measurement unit (inertial measurement unit, IMU), a lidar, a millimeter wave radar, an ultrasonic radar, and a camera apparatus.

A part or all functions of the vehicle 100 may be controlled by the computing platform 150. The computing platform 150 may include processors 151 to 15n (where n is a positive integer). The processor is a circuit having a signal processing capability. In an implementation, the processor may be a circuit having an instruction reading and running capability, for example, a central processing unit (central processing unit, CPU), a microprocessor, a graphics processing unit (graphics processing unit, GPU) (which may be understood as a microprocessor), or a digital signal processor (digital signal processor, DSP). In another implementation, the processor may implement a specific function based on a logical relationship of a hardware circuit. The logical relationship of the hardware circuit is fixed or reconfigurable. For example, the processor is a hardware circuit implemented by an application-specific integrated circuit (application-specific integrated circuit, ASIC) or a programmable logic device (programmable logic device, PLD), for example, a field programmable gate array (Field Programmable Gate Array, FPGA). In the reconfigurable hardware circuit, a process in which the processor loads a configuration document to implement hardware circuit configuration may be understood as a process in which the processor loads instructions to implement functions of a part or all of the foregoing units. In addition, the processor may alternatively be a hardware circuit designed for artificial intelligence, and may be understood as an ASIC, for example, a neural network processing unit (neural network processing unit, NPU), a tensor processing unit (tensor processing unit, TPU), or a deep learning processing unit (deep learning processing unit, DPU). In addition, the computing platform 150 may further include a memory. The memory is configured to store instructions. A part or all of the processors 151 to 15n may invoke the instructions in the memory, to implement a corresponding function described in embodiments of this application.

The vehicle in this application may include a road vehicle, an industrial device, an agricultural device, an entertainment device, or the like. For example, the vehicle may include an uncrewed vehicle. The vehicle is a vehicle in a broad sense, and may be a means of transportation (such as a commercial vehicle, a passenger vehicle, a motorcycle, a flying vehicle, or a train), an industrial device (such as a robot based on a machine vision system), an industrial vehicle (such as a forklift, a trailer, or a tractor), an engineering vehicle (such as an excavator, a bulldozer, or a crane), an agricultural device (such as a lawn mower, or a reaper), amusement equipment, a toy vehicle, or the like. A type of the vehicle is not specifically limited in embodiments of this application. In addition, an application object of embodiments of this application is not limited to a vehicle, and may be further extended to a water vehicle or an air vehicle, for example, an uncrewed yacht or an uncrewed aerial vehicle.

A MEMS, also referred to as a micro-electro-mechanical system or a micro-electro-mechanical system, refers to a miniature component or system that integrates a micro-sensor, a micro-actuator, a micro-mechanical structure, a signal processing and control circuit, a high-performance electronic integrated component, an interface, communication, and a power supply through conventional semiconductor processes and materials. A MEMS micromirror is a galvanometer manufactured by using a MEMS manufacturing process standard.

It should be understood that the MEMS micromirror in this application may also be referred to as a MEMS lens, a MEMS rotation mirror, a MEMS scanning mirror, a MEMS scanning micromirror, or the like. This is not limited in embodiments of this application.

A lidar used in a self-driving vehicle usually performs a laser scanning operation based on the MEMS micromirror, to obtain information about an environment around the vehicle. Imaging quality of the lidar is a main manifestation of competitiveness of the lidar, and the imaging quality of the lidar is inseparable from accurate control of rotation of the MEMS micromirror. Therefore, vibration precision of the MEMS micromirror may be improved in a closed-loop control manner. However, high-precision closed-loop control depends on a high-precision detection means. Therefore, to implement precise control on the MEMS micromirror, tilt angles of the MEMS micromirror need to be accurately measured. Because a vibration amplitude, a phase, and the like of the MEMS micromirror change with a voltage, atmospheric humidity, a temperature, and the like, precise running of the MEMS micromirror needs to be implemented based on a real-time state of the MEMS micromirror. For example, the processor may obtain real-time tilt angles of the MEMS micromirror, to implement real-time control on rotation angles of the MEMS micromirror.

In addition, the MEMS micromirror may be further used in a projector, a laser processing device, and the like.

Currently, angle measurement of the MEMS micromirror may be implemented by using the following two methods.

Method 1: The method 1 is a method based on piezoresistive measurement. To be specific, a piezoresistive sensor is integrated onto or around a cantilever beam of the MEMS micromirror. As the micromirror deflects, the cantilever beam deforms, so that the piezoresistive sensor generates a signal, and then a rotation angle of the micromirror is analyzed by using the signal.

Method 2: The method 2 is a method based on piezoelectric measurement. To be specific, a piezoelectric sensor is integrated onto or around a cantilever beam of the MEMS micromirror. As the micromirror deflects, the cantilever beam deforms, so that an output of the piezoelectric sensor changes, and then a rotation angle of the micromirror is analyzed based on a change of the signal.

However, both the method 1 and the method 2 need to be processed based on a product of the MEMS micromirror. The processing process is complex, and manufacturing difficulty of the MEMS micromirror is increased. In addition, sensing precision of the piezoresistive sensor or the piezoelectric sensor is affected by a temperature. For example, a temperature drift problem exists. In addition, because the MEMS micromirror deflects relative to two rotational axes (a fast axis and a slow axis), and the piezoresistive sensor or the piezoelectric sensor measures deflection relative to the two rotational axes at the same time, a coupling error caused by the deflection relative to the two axes of the MEMS micromirror exists. The temperature drift refers to a change of a parameter of a semiconductor device caused by a temperature change, and is a main reason why a sensor detection element generates a zero-point drift phenomenon. Therefore, zero-point drift is generally referred to as temperature drift, which is referred to as temperature drift for short. In addition, the piezoelectric sensor or the piezoresistive sensor obtains a pressure value of a mirror tilt of the MEMS micromirror on the beam, and the tilt angles of the MEMS micromirror are indirectly resolved by using the pressure value. This method has poor accuracy, low sensitivity to a tilt motion of the MEMS micromirror, and slow response. Moreover, when errors caused by the temperature drift and coupling of the two axes are considered, it is difficult to accurately measure the tilt angles of the MEMS micromirror in real time by using the foregoing method 1 and method 2.

It can be learned that, angle measurement precision of the foregoing method 1 and method 2 is poor, and error impact caused by the temperature drift and biaxial deflection coupling cannot be eliminated. In view of this, embodiments of this application provide an angle measurement apparatus and a lidar scanning system. A specially designed grating cover and a laser transceiver apparatus are used for decoupling measurement of biaxial deflection, and measurement errors generated based on temperature drift can be eliminated, thereby improving accuracy of measurement on deflection angles of a MEMS micromirror.

FIG. 2 is a diagram of an angle measurement apparatus 200 according to an embodiment of this application. The apparatus is configured to measure tilt angles of a MEMS micromirror relative to a first rotational axis and a second rotational axis. It should be understood that the tilt angles of the MEMS micromirror may also be referred to as rotation angles, or may be referred to as angles of rotation. This is not limited in embodiments of this application.

For example, the first rotational axis may be a fast axis of the MEMS micromirror, and the second rotational axis may be a slow axis of the MEMS micromirror. Generally, the fast axis and the slow axis of the MEMS micromirror intersect and are perpendicular to each other, so that the MEMS micromirror can implement two-dimensional rotation in a horizontal direction and a vertical direction, thereby implementing a two-dimensional laser scanning function of a lidar.

The apparatus 200 includes:
a light source 211; and
a photoelectric detector matrix 212, including N photoelectric detector arrays 2121, where the photoelectric detector matrix 212 and the light source 211 are located on a same plane, N is greater than or equal to 4, and the light source 211 is located at a central position of the photoelectric detector matrix.

In some possible embodiments, the photoelectric detector array 2121 may include four photoelectric detectors in a 2×2 (a quantity of rows×a quantity of columns) arrangement, and the N photoelectric detector arrays 2121 are separately located around the light source 211. For example, when the photoelectric detector matrix includes four photoelectric detector arrays 2121, the four photoelectric detector arrays 2121 are respectively located at the upper right, the upper left, the lower right, and the lower left of the light source 211. In other words, the four photoelectric detector arrays 2121 included in the photoelectric detector matrix 212 are also in a 2×2 arrangement. Certainly, the photoelectric detector array 2121 may alternatively include another quantity of photoelectric detectors. For example, the photoelectric detector array 2121 includes two photoelectric detectors in a 2×1 arrangement. The photoelectric detector matrix 212 may include eight photoelectric detector arrays 2121. Correspondingly, the eight photoelectric detector arrays 2121 may be in a 2×4 arrangement. The rest may be deduced by analogy.

It should be understood that an arrangement of the photoelectric detector matrix 212 is a form proposed in the foregoing example because the MEMS micromirror has a regular rectangular shape, and the photoelectric detectors are in a matrix arrangement. This is more suitable for measuring the tilt angles of the MEMS micromirror.

Based on the foregoing technical solution, the tilt angles of the MEMS micromirror relative to the two axes can be measured, and distribution of light spots of a reflected laser can be measured by using a measurement array including a plurality of photoelectric detectors, so that response time of a sensor can be accelerated, to implement real-time measurement on an angle change of the MEMS micromirror. In addition, the apparatus 200 directly collects intensity of a light beam reflected by the MEMS micromirror to resolve measurement on the tilt angles of the MEMS micromirror. Therefore, precision of this solution is higher than precision of a solution of measuring the tilt angles of the MEMS micromirror through a piezoresistive sensor or a piezoelectric sensor. In addition, a compact arrangement of an overall structure of the photoelectric detector matrix is achieved with small occupied space, so that the apparatus 200 is more easily disposed in a lidar scanning system, and can directly measure angles of the MEMS micromirror.

In some possible embodiments, the light source 211 is configured to emit a laser. For example, the light source 211 may be an LED. However, considering that a light emitting characteristic of the LED is easily affected by a temperature, to be specific, a higher temperature indicates lower intensity of a laser emitted by the LED, a VCSEL may be further used as the light source 211 of the apparatus 200, to reduce impact of the temperature on light emitting performance of the light source 211.

In some possible embodiments, the light source 211 is configured to emit a light beam to a first surface of the MEMS micromirror, the first surface of the MEMS micromirror is coated with a reflective layer, and the MEMS micromirror is configured to reflect the light beam to the photoelectric detector matrix 212. In other words, after being reflected by the first surface of the MEMS micromirror that is coated with the reflective layer, the light beam emitted by the light source 211 can be received by the photoelectric detector matrix 212. The first surface of the MEMS micromirror faces a plane on which the light source 211 and the photoelectric detector matrix 212 are located.

For example, when the light source 211 is the VCSEL, the light beam is a laser beam.

Based on the foregoing technical solution, the reflective layer is formed on the first surface of the MEMS micromirror through a coating process, so that a loss of reflected light can be greatly reduced. This helps increase an amplitude of light intensity received by the photoelectric detector matrix, thereby helping improve angular resolution of the apparatus 200.

In some possible embodiments, the photoelectric detector may be a photo diode (PD). Therefore, the photoelectric detector matrix may also be referred to as a PD matrix, and the photoelectric detector arrays 2121 may also be referred to as PD arrays. It should be noted that the photoelectric detector is also referred to as a photodetector, and is usually referred to as a PD for short. However, the photo diode provided in embodiments of this application may also be referred to as a PD for short. To avoid confusion, it is stated herein that a PD subsequently mentioned in embodiments of this application specifically refers to as a photo diode.

Based on the foregoing technical solution, the PD has a characteristic of a high response speed, and the photoelectric detector matrix includes a plurality of PDs, so that a large amount of measurement data can be quickly obtained based on the photoelectric detector matrix for angle measurement, and the angle measurement apparatus responds quickly.

It should be understood that the angle measurement apparatus provided in embodiments of this application is not limited to measuring the tilt angles of the MEMS micromirror, and may further measure tilt angles of another measured object. In addition, based on a design idea of the angle measurement apparatus in this application, when the measured object tilts relative to only one axis, the photoelectric detector matrix 212 may be correspondingly adjusted to a row matrix or a column matrix, to measure the tilt angles of the measured object.

In some possible embodiments, when a size of the measured object is large, a quantity of rows and/or a quantity of columns of the photoelectric detector matrix may be adaptively increased, and a quantity of photoelectric detectors included in the photoelectric detector array 2121 may be increased. The same applies in reverse. When the measured object has another shape, for example, a diamond shape, an arrangement of the photoelectric detector array 2121 may also be adaptively changed, and an arrangement of the photoelectric detectors in the photoelectric detector array 2121 may be changed. For example, both the arrangements may be adjusted to a diamond arrangement.

In some possible embodiments, the light source 211 and the photoelectric detector matrix 212 may be deployed on a same silicon substrate 214. Based on the apparatus structure provided in the foregoing embodiment, the light source 211 may be located at a central position of the silicon substrate 214, and the light source 211 uses the foregoing VCSEL, so that the light source 211 emits laser in a direction vertically upward from the silicon substrate 214. The N photoelectric detector arrays are separately located around the light source 211. For example, refer to FIG. 2. The light source 211 is located at the central position of the photoelectric detector matrix 212. In addition, a pad 213 is further provided on the silicon substrate 214. The pad 213 is configured to achieve electrical connection and power supply for the photoelectric detector matrix 212 and electronic components such as the light source 211.

In some possible embodiments, the silicon substrate 214 may be made of a material such as silicon or ceramic.

Based on the foregoing technical solution, the light source 211 and the photoelectric detector matrix 212 are disposed on the same silicon substrate 214, to form an angle measurement apparatus with high integration. In addition, other elements, such as a pad, a mark, and a lead, are further conveniently provided on the silicon substrate 214, to further increase integration of the apparatus.

In some possible embodiments, the apparatus 200 further includes an optical lens group 215.

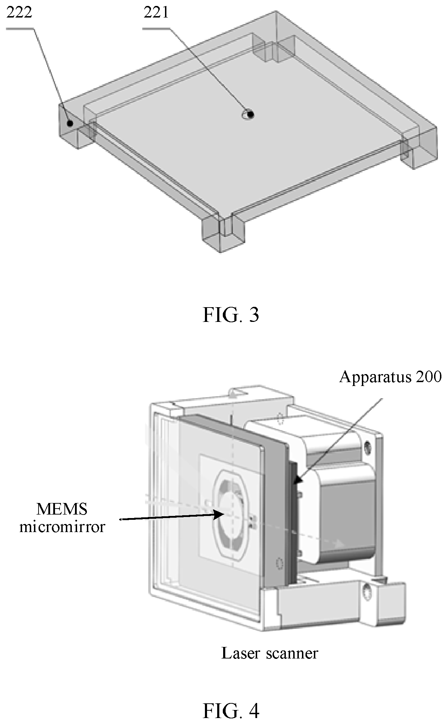

FIG. 3 is a diagram of an optical lens group 215 according to an embodiment of this application.

The optical lens group 215 includes a lens 221 and a filter film 222. The lens 221 corresponds to a position of the light source 211, so that a light beam can be emitted through the lens 221, and the light beam is shaped. For example, an angle of the light beam is expanded. The filter film 222 covers a side of the optical lens group 215, to shield lateral light from a side of the light source 211, and avoid impact of errors in angle measurement caused by the lateral light.

In some possible embodiments, the lens 221 is a divergent lens, and is configured to expand a divergence angle of a light beam emitted by the light source 211, to enlarge a measurement range of the apparatus 200, and enable lasers to exhibit Gaussian distribution, to form Gaussian light spots. A feature of the light spot is that light intensity is maximum at the center, and the light intensity gradually decreases along a radial direction. A light beam with this feature is reflected by the MEMS micromirror and is received by the photoelectric detector matrix 212, so that the tilt angles of the MEMS micromirror can be resolved based on distribution of signal strength output by the photoelectric detectors in the photoelectric detector matrix 212.

It should be understood that, an example in which the light source 211 is the VCSEL is used for description. A laser emitted by the light source 211 is usually in a beam form. In this case, after angle expansion is performed through the lens 221, an emission angle of the laser beam is further expanded. It is assumed that the lens 221 does not have a laser angle expansion function, and a laser beam emitted by the lens 221 can cover a first range. Because the laser beam is usually narrow, it may be difficult for the laser beam to cover the entire MEMS micromirror. Therefore, it is difficult to measure an overall tilt state of the MEMS micromirror. In this case, if the lens 221 has the laser angle expansion function, the laser beam emitted by the lens 221 can cover a second range, and the second range is greater than the first range. This helps cover the entire MEMS micromirror by using the laser beam.

Based on the foregoing technical solution, divergence processing can be performed on a light beam by using the optical lens group 215 of a special structure, to enlarge the measurement range of the apparatus 200, and enable intensity distribution of light spots formed on the photoelectric detector matrix 212 to follow Gaussian distribution, so that the tilt angles of the MEMS micromirror can be resolved based on distribution of signal strength output by the photoelectric detectors in the photoelectric detector matrix 212. In addition, based on the filter film of the optical lens group 215, ambient light from a lateral direction is further shielded, thereby reducing measurement errors.

FIG. 4 is a diagram of a deployment position of the angle measurement apparatus 200 according to an embodiment of this application. The apparatus 200 is disposed in a laser scanner of a lidar, and the laser scanner performs laser scanning through the MEMS micromirror.

Refer to FIG. 4. The apparatus 200 may be disposed behind the MEMS micromirror. To be specific, the light source 211 of the apparatus 200 may emit a light beam perpendicularly to a bottom surface of the MEMS micromirror (also referred to as a back side of the MEMS micromirror), and the light beam is reflected by the MEMS micromirror to the photoelectric detector matrix 212. Based on signal strength output by each photoelectric detector, high-precision deflection angle measurement of the MEMS micromirror can be implemented. The following describes an angle measurement principle of the apparatus 200.

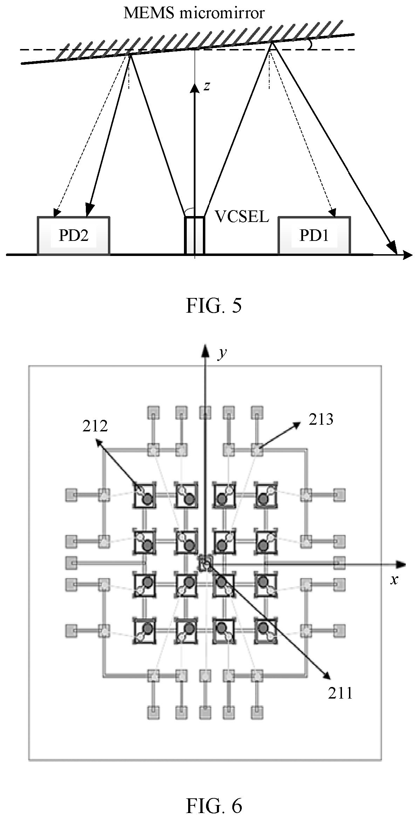

FIG. 5 is a diagram of the angle measurement principle of the apparatus 200 according to an embodiment of this application. In the principle diagram, an example in which the light source 211 is the VCSEL, the photoelectric detector is the PD (where FIG. 5 is a front view, only two PDs are shown for description, and a quantity of PDs is not limited), and the MEMS micromirror tilts relative to the fast axis is used for description.

Refer to FIG. 5. When the MEMS micromirror does not tilt, the MEMS micromirror is parallel to a plane on which the apparatus 200 is located. The VCSEL emits a laser to a back side (in a z-axis direction) of the MEMS micromirror. A PD 1 and a PD 2 on a same side of the VCSEL receive the laser reflected by the MEMS micromirror (where a propagation path of the laser is indicated by a dashed arrow). Light spots corresponding to the laser emitted by the VCSEL are the foregoing Gaussian light spots. When the MEMS micromirror deflect along the fast axis, the MEMS micromirror is not parallel to the plane on which the apparatus 200 is located, the VCSEL emits a laser to the back side of the MEMS micromirror, and the PD 1 and the PD 2 on the same side of the VCSEL receive the laser reflected by the MEMS micromirror (a propagation path of the laser is indicated by a solid arrow). It can be learned that a position of the light spot changes compared with that before the MEMS micromirror tilts, and intensity of lasers received by the PD 1 and the PD 2 changes due to such impact. Therefore, the tilt angles of the MEMS micromirror may be calculated based on outputs of the PD 1 and the PD 2. In other words, mapping relationships exist between an output of the photoelectric detector matrix 212 and the tilt angles of the MEMS micromirror.

It should be understood that FIG. 5 shows only measurement on the tilt angles of the MEMS micromirror relative to the fast axis. For measurement on the tilt angles of the MEMS micromirror relative to the fast axis and the slow axis, the tilt angles of the MEMS micromirror need to be measured by using a two-dimensionally distributed PD array. A measurement principle is similar to that in the foregoing descriptions, and details are not described herein again.

FIG. 6 is a design diagram of the silicon substrate 214 according to an embodiment of this application.

Refer to FIG. 6. Alignment marks, leads, and the pad 213 of the light source 211 and photoelectric detector matrix 212 are deployed on an upper surface of the silicon substrate 214 through deposition, laser etching, or the like. The alignment marks provide a reference for packaging of the light source 211 and the photoelectric detectors, and a conducting wire is arranged below positions of the light source 211 and the photoelectric detectors, and is connected to the pad 213. Because cathodes of the light source 211 and the photoelectric detector are located on a bottom surface, the light source 211 and the photoelectric detectors may be bonded to the silicon substrate 214 by using conductive silver adhesive, and connected to the pad 213. Anodes of the photoelectric detector and the light source 211 may be connected to the pad 213 in a wire bonding manner.

In some possible embodiments, the apparatus 200 further includes a printed circuit board (printed circuit board, PCB). The PCB carries the silicon substrate 214 and all components deployed on the silicon substrate 214.

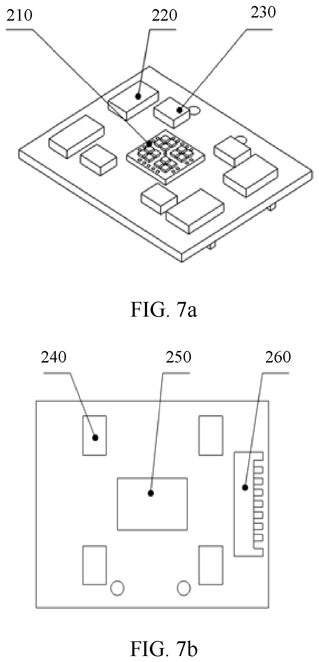

FIG. 7a and FIG. 7b are design diagrams of a PCB according to an embodiment of this application.

Refer to FIG. 7a and FIG. 7b. The PCB is further provided with amplifiers. The amplifiers (220, 230, 240) mainly form a transimpedance amplification circuit, an inverting circuit, a follower circuit, and the like for a sensor output signal, to implement analog amplification of the output signal.

In addition, the PCB is further provided with a power supply module 250 and a flexible flat cable interface 260. After the foregoing signal is processed by the apparatus 200 and the amplifiers (220, 230, 240), the signal is finally connected to an external circuit board through the flexible flat cable interface 260, to implement a result output.

Based on the foregoing technical solution, the apparatus 200 is integrated, and all measurement elements are carried on the PCB, so that the apparatus 200 is powered on and used. In addition, the apparatus 200 is small in size and is easily disposed in a lidar.

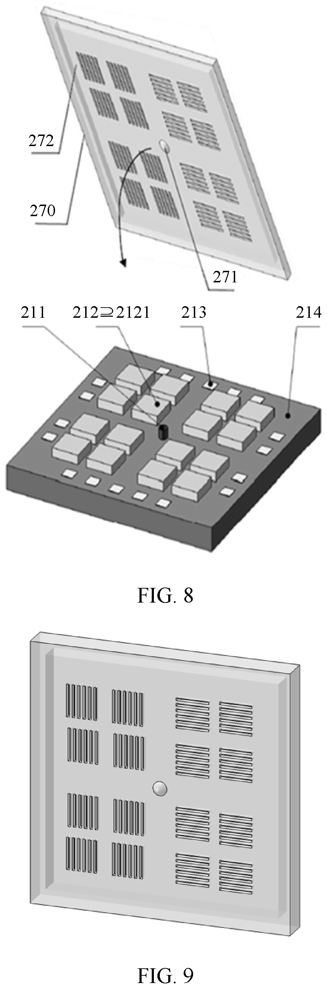

FIG. 8 is a diagram of an angle measurement apparatus 300 according to an embodiment of this application.

Similar to the angle measurement apparatus 200, the angle measurement apparatus 300 also includes a light source 211 and a photoelectric detector matrix 212, and the photoelectric detector matrix 212 includes N photoelectric detector arrays 2121. The photoelectric detector matrix 212 and the light source 211 are located on a same plane. N is greater than or equal to 4. On this basis, the apparatus 300 further includes a grating cover 270. The grating cover 270 includes N grating arrays 272. The grating cover 270 is disposed on the photoelectric detector matrix 212. Positions of the N grating arrays 272 are in one-to-one correspondence with positions of the N photoelectric detector arrays 2121. A stripe direction of a first part of gratings in the N grating arrays 272 is a first direction, a stripe direction of a second part of gratings in the N grating arrays 272 is a second direction, the first direction is parallel to a first rotational axis of a MEMS micromirror, and the second direction is parallel to a second rotational axis of the N photoelectric detector arrays 2121.

It should be understood that the light source 211 and the photoelectric detector matrix 212 in the apparatus 200 are the same as those in the apparatus 300. Therefore, for corresponding extension descriptions of the light source 211 and the photoelectric detector matrix 212 in the apparatus 300, refer to the foregoing corresponding embodiments. Details are not described herein again.

For example, the grating in embodiments of this application is presented in a form of a rectangular grid, and each grid includes a plurality of grating stripes. The grating stripe in embodiments of this application may also be referred to as a grating strip. A name having a same meaning as the grating stripe is not limited in embodiments of this application.

It should be understood that the grating in embodiments of this application is an optical element including a series of equally spaced parallel grating strips (or stripes), and a stripe width of the grating is equal to a width of a gap between the stripes. However, a distance between the grating stripes, the stripe width, and the width of the gap between the stripes are not limited in embodiments of this application.

In some possible embodiments, the grating cover 270 further includes a lens 271, and the lens may be the lens 221 in the apparatus 200. Similar to the foregoing embodiment, the lens 271 may be a divergent lens, and is configured to expand a divergence angle of a light beam emitted by the light source 211, to enlarge a measurement range of the apparatus 300, and enable lasers to exhibit Gaussian distribution, to form Gaussian light spots. A feature of the light spot is that light intensity is maximum at the center, and the light intensity gradually decreases along a radial direction. A light beam with this feature is reflected by the MEMS micromirror and is received by the photoelectric detector matrix 212, so that tilt angles of the MEMS micromirror can be resolved based on distribution of signal strength output by photoelectric detectors in the photoelectric detector matrix 212.

In some possible embodiments, a first spacing exists between a first grating in the first part of gratings and a second grating adjacent to the first grating in the second direction, a stripe of the first grating and a stripe of a third grating adjacent to the first grating in the first direction are staggered by a second spacing in the second direction, the first spacing exists between a fourth grating in the second part of gratings and a fifth grating adjacent to the fourth grating in the first direction, and a stripe of the fourth grating and a stripe of a sixth grating adjacent to the fourth grating in the second direction are staggered by the second spacing in the first direction.

In some possible embodiments, the first spacing is (n+1/4)d or (n+1/2)d, the second spacing is m×d, n and m are integers, and d is the stripe width of the grating.

FIG. 9 is a diagram of a grating cover 270 according to an embodiment of this application.

Refer to FIG. 9. It is assumed that the photoelectric detector matrix 212 includes four photoelectric detector arrays 2121, and each photoelectric detector array 2121 includes photoelectric detectors in a 2×2 arrangement. Correspondingly, the grating cover 270 also includes four grating arrays 272 that correspond to an arrangement of the photoelectric detectors in the photoelectric detector matrix 212, each grating array 272 also includes four gratings in a 2×2 arrangement, and the four grating stripes are the same. The four grating arrays 272 are arranged at the upper right, the upper left, the lower left, and the lower right of the grating cover 270. According to the description sequence, the four grating arrays may be referred to as a first grating array, a second grating array, a third grating array, and a fourth grating array for short. Stripes of the first grating array and the fourth grating array are horizontal stripes and belong to the first part of gratings, and stripes of the second grating array and the third grating array are vertical stripes and belong to the second part of gratings.

It should be understood that although stripes of all gratings in each grating array are consistent, stripe deployment positions of the gratings are not aligned. Using the first grating array as an example, a deployment position between a grating stripe located at the upper left and a grating stripe located at the upper right has a specific deviation in a vertical direction. It can be learned from the foregoing embodiment that the deviation is equal to one stripe width. Similarly, a deployment position between a grating stripe located on the lower left of the first grating array and a grating stripe located on the lower right of the first grating array also has a specific deviation in a horizontal direction. This is to add a light spot distribution characteristic to a laser light spot formed through screening by the grating cover 270. The characteristic can be used for analyzing tilt angles of a measured object, and can eliminate error impact caused by zero-point drift. For a calculation principle, refer to corresponding descriptions in subsequent embodiments.

The grating cover 270 is used in a scenario in which the tilt angles of the MEMS micromirror are measured, where the grating stripes of the first grating array and the fourth grating array are parallel to a slow axis of the MEMS micromirror, and the grating stripes of the second grating array and the third grating array are parallel to a fast axis of the MEMS micromirror. In this case, when the MEMS micromirror tilts relative to the fast axis, impact on outputs of photoelectric detectors corresponding to the second grating array and the third grating array is large, and impact on outputs of photoelectric detectors corresponding to the first grating array and the fourth grating array is small. In an ideal state, in a process in which the MEMS micromirror tilts relative to the slow axis, only the outputs of the photoelectric detectors corresponding to the second grating array and the third grating array are affected, and the outputs of the photoelectric detectors corresponding to the first grating array and the fourth grating array are not affected. The same applies in reverse.

For ease of description, the fast axis of the MEMS micromirror is referred to as a y axis for short, the slow axis of the MEMS is referred to as an x axis for short, and the light source 211 is a VCSEL. When the MEMS micromirror tilts relative to the y axis, as the MEMS micromirror tilts, a laser reflective point in contact with the MEMS micromirror shifts in an x-axis direction. Considering that the grating cover 270 has a specific thickness, in a process in which the laser passes through a vertical-stripe grating after the reflective point shifts, a side surface of the vertical-stripe grating may have strong shielding impact on the reflected laser. In this case, distribution of light spots formed by the vertical-stripe grating changes greatly compared with that before the MEMS micromirror tilts. In a process in which the laser passes through a horizontal-stripe grating after the reflective point shifts, because the reflective point of the laser shifts in the x-axis direction, shielding impact caused by the horizontal-stripe grating on the reflected laser is weak. Therefore, distribution of light spots formed by the horizontal-stripe grating changes slightly compared with that before the MEMS micromirror tilts, and even does not change. A change of the distribution of the light spots can be detected by the photoelectric detector matrix, so that based on an output of the photoelectric detector matrix, it can be determined that the MEMS micromirror tilts around the y axis and a corresponding tilt angle can be determined. The same applies in reverse.

It can be learned that, introduction of the grating cover 270 reduces sensitivity of a part of photoelectric detectors (for example, the photoelectric detectors corresponding to the first grating array and the fourth grating array) in measuring a change of distribution of laser light spots in the x-axis direction, and also reduces sensitivity of another part of photoelectric detectors (for example, the photoelectric detectors corresponding to the second grating array and the third grating array) in measuring a change of distribution of laser light spots in a y-axis direction.

Based on the foregoing technical solution, even if the MEMS micromirror tilts relative to both the x axis and the y axis, under impact of the grating cover on the light spots, a part of photoelectric detectors in the photoelectric detector matrix can be dedicated to measuring a tilt angle of the MEMS micromirror relative to the y axis, and another part of photoelectric detectors can be dedicated to measuring a tilt angle of the MEMS micromirror relative to the x axis, to decouple an action of measuring the tilt angles of the MEMS micromirror relative to the two axes.

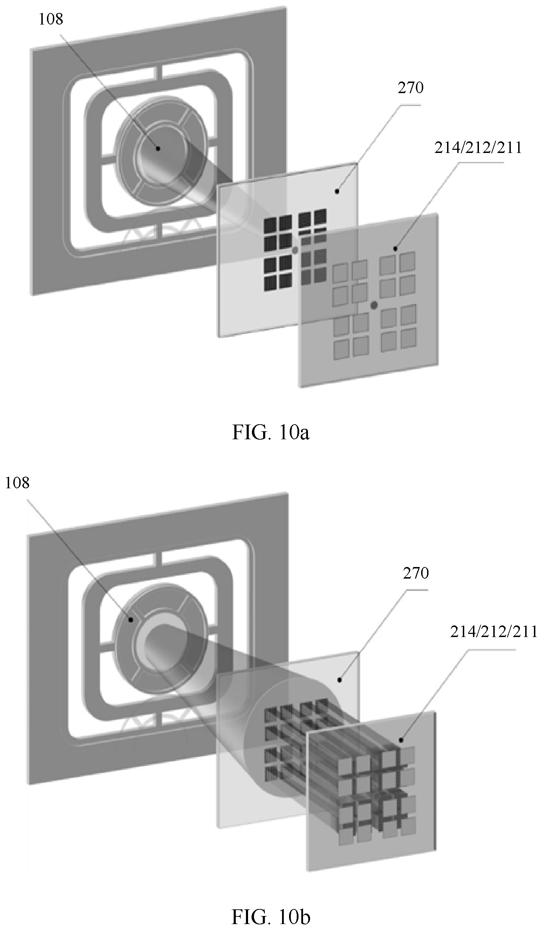

FIG. 10a and FIG. 10b are diagrams of laser emission and reception based on the grating cover 270 according to an embodiment of this application.

Refer to FIG. 10a. The light source 211 emits a laser to the lens 271 in the grating cover 270, and the laser radiates a diverged laser on a back side of a MEMS micromirror 108 based on a divergence effect of the lens.

Refer to FIG. 10b. A laser is reflected on the back side (a first surface) of the MEMS micromirror 108, and is reflected to the grating cover 270. The grating cover 270 screens reflected light, and finally emits a laser obtained through screening onto a photoelectric detector in one-to-one correspondence to each grating, and forms light spots on the photoelectric detector matrix 212. Based on a function of the grating cover 270, the light spots are partially in a horizontal stripe shape (parallel to an x axis of the MEMS micromirror 108), and partially in a vertical stripe shape (parallel to a y axis of the MEMS micromirror 108). The photoelectric detector matrix 212 measures, based on a change of distribution of the light spots in the horizontal stripe shape, a tilt angle of the MEMS micromirror 108 relative to the y axis, to determine a first angle component; and measures, based on a change of distribution of the light spots in the vertical stripe shape, a tilt angle of the MEMS micromirror 108 relative to the x axis, to determine a second angle component. Then the tilt angles of the MEMS micromirror 108 relative to the two axes may be determined based on the first angle component and the second angle component.

Based on the foregoing technical solution, an action of measuring the tilt angles of the MEMS micromirror relative to the two axes can be decoupled, thereby helping avoid measurement errors caused by coupling of the MEMS micromirror relative to the two axes, eliminating the measurement error caused by coupling of the MEMS micromirror relative to the two axes, and improving accuracy of measurement on the tilt angles of the MEMS micromirror.

In some possible embodiments, the lens 271 is further configured to enable distribution of light spots formed by the light beam emitted by the light source 211 to correspond to stripe directions and stripe shapes of the N grating arrays 272 in the grating cover 270. For example, the function may be implemented by providing a corresponding light shielding portion on the lens 271.

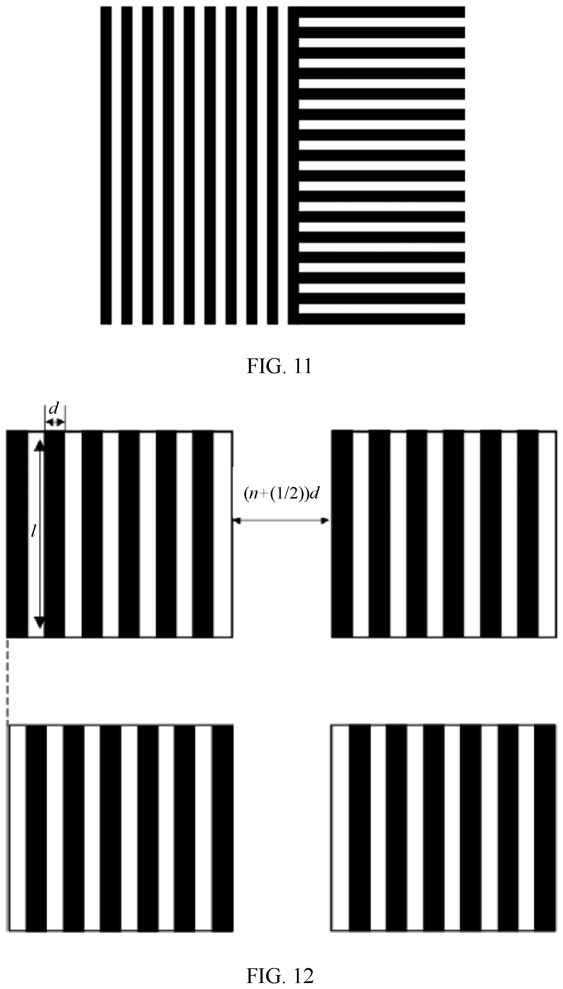

FIG. 11 is a diagram of stripe-shaped light spots formed by an effect of the lens light shielding portion according to an embodiment of this application.

Refer to FIG. 11. A distribution form of the light spots is consistent with a distribution form of the grating stripes of the grating cover 270 shown in FIG. 9, that is, the light spots are presented as square stripes, stripes of light spots on a left part and a right part are perpendicular to each other, and spacings between the stripes are equal. In addition, directions corresponding to the two parts of stripes are respectively parallel to the fast axis (the y axis) and the slow axis (the x axis) of the MEMS micromirror. A vertical-stripe spot on the left half part may be used for measuring a tilt angle of the MEMS micromirror relative to the y axis, and a horizontal-stripe spot on the right half part may be used for measuring a tilt angle of the MEMS micromirror relative to the x axis.

In some possible embodiments, quantities of gratings in the first part of gratings and the second part of gratings in the grating cover 270 are a multiple of 2, for example, 8, 16, or 32. Further, the quantities of gratings in the first part of gratings and the second part of gratings in the grating cover 270 may also be equal.

That the distribution of the light spots corresponds to the stripe directions of the N grating arrays 272 in the grating cover 270 means the following: Gratings included in the N grating arrays are divided into the first part of gratings and the second part of gratings, the stripe direction of the first part of gratings is the first direction, and the stripe direction of the second part of gratings is the second direction. In this case, the light spots formed through the light shielding portion also have stripe shapes, and the light spots may also be divided into a first part of light spots and a second part of light spots based on stripe directions. A stripe direction of the first part of light spots is the first direction, which is the same as the stripe direction of the first part of gratings, and a stripe direction of the second part of light spots is the second direction, which is the same as the stripe direction of the second part of gratings.

That the distribution of the light spots corresponds to the stripe shapes of the N grating arrays 272 in the grating cover 270 means the following: A geometric parameter (for example, a stripe width) of the stripes formed by the light spots is equal to a geometric parameter of the stripes of the gratings, and a parameter difference between the geometric parameter of the stripes formed by the light spots and the geometric parameter of the stripes of the gratings is within a preset difference range.

Therefore, based on the light shielding portion, the light spots formed on the photoelectric detector matrix also have stripe shapes. Using the first grating and the third grating in the first part of gratings in the grating cover 270 shown in FIG. 9 as an example, a second distance between the stripe of the first grating and the stripe of the third grating in the second direction is one stripe width d. Refer to FIG. 11. It can be learned that the light spots have complete and continuous straight stripes in the first direction. In this case, signal light intensity to which a first photoelectric detector corresponding to the first grating responds is different from signal light intensity to which a second photoelectric detector corresponding to the third grating responds. For example, both the first grating and the third grating include three grating strips, that is, there are four light-transmitting openings. If the first photoelectric detector can respond to four complete stripe spots, the second photoelectric detector cannot respond to the light spots because the stripe spots are blocked by the three grating strips of the third grating.

It can be learned that, when a deflection angle of the MEMS micromirror periodically changes, a phase difference of π/2 exists between a change curve of the signal light intensity to which the first photoelectric detector responds and a change curve of the signal light intensity to which the second photoelectric detector responds. Based on a signal light intensity change characteristics between the photoelectric detectors, a rotation direction and a rotation angle of the MEMS micromirror can be resolved, and measurement errors caused by temperature drift can be resolved. For details about a measurement principle and process, refer to subsequent embodiments.

The following describes, by using a detailed example, a principle of measuring tilt angles of an object by the apparatus 300 provided in this application.

For the grating cover 270 used in this example, refer to FIG. 9. For a distribution form of stripe-shaped light spots formed by the light source 211 through the light shielding portion of the lens, refer to FIG. 11.

FIG. 12 is a diagram of distribution of grating strips according to an embodiment of this application. The grating strip may be understood as the grating stripe provided in the foregoing embodiment.

Using the second grating array as an example, the second grating array includes four gratings, denoted as a grating 1 (at an upper left position of the second grating array), a grating 2 (at an upper right position of the second grating array), a grating 3 (at a lower left position of the second grating array), and a grating 4 (at a lower right position of the second grating array), and each grating includes a plurality of grating strips in the vertical direction. A width of each grating strip is d, a length is l, and an interval between the plurality of grating strips may also be d. The grating strips are used for blocking a reflected laser, and the interval between the grating strips is used for transmitting the reflected laser. Because the gratings are in one-to-one correspondence with the photoelectric detectors (using PDs as an example), projection of each grating in the grating cover 270 in a direction perpendicular to the PD can cover the corresponding PD.

In addition, an interval L may also be set between the gratings in the second grating array. The interval L may be set to a multiple of the grating strip width d, and the multiple may be an integer multiple, or may be a non-integer multiple. Based on the foregoing embodiment, it can be learned that L=(n+(1/4))d or L=(n+(1/2))d, where n is a positive integer, and L=(n+(1/2))d is used in the example in FIG. 12.

Based on the foregoing embodiment, it can be learned that positions of the grating strips of the four gratings in the second grating array are not completely aligned. Using the grating 1 and the grating 3 in the second grating array as an example, a second spacing exists between the grating strips of the grating 3 and the grating strips of the grating 1 in the x-axis direction. Refer to FIG. 12. The second spacing may be equal to the grating strip width d. The same applies to distribution manners of the grating strips of the grating 2 and the grating 4.

When the MEMS micromirror is used, the MEMS micromirror needs to perform periodic angular rotation relative to the two axes. Therefore, using four PDs corresponding to the second grating array as an example, output signals of the four PDs also correspondingly change periodically. For ease of description, in embodiments of this application, a PD corresponding to the grating 1 is denoted as a PD 1, a PD corresponding to the grating 2 is denoted as a PD 2, a PD corresponding to the grating 3 is denoted as a PD 3, and a PD corresponding to the grating 4 is denoted as a PD 4.

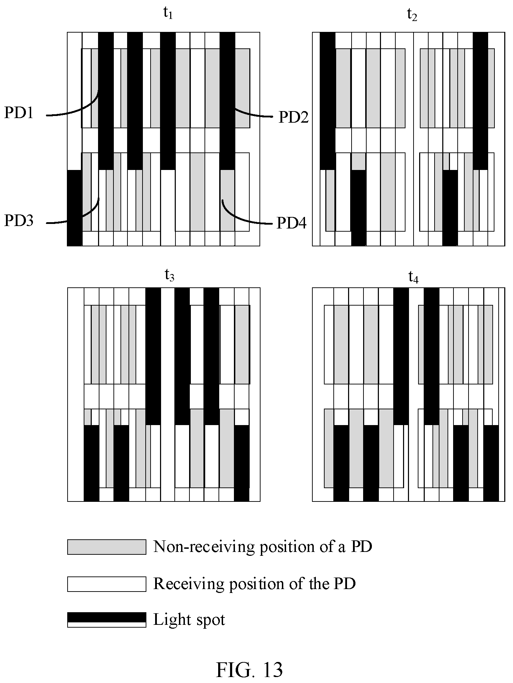

FIG. 13 is a diagram of distribution of light spots on a surface of a PD within a MEMS micromirror rotation period according to an embodiment of this application.

FIG. 13 shows distribution of light spots on surfaces of the PDs corresponding to the four gratings in the second grating array. t₁ and t₄ respectively correspond to a start moment and an end moment of the MEMS micromirror rotation period, and time intervals between t₁, t₂, t₃, and t₄ are the same. Non-receiving positions of the PD correspond to positions of the grating strips of the grating. Because the grating strips block the positions, no optical signal can be received at this positon, that is, no light spot can be formed. Receiving positions of the PD correspond to gap positions between the grating strips. The positions are not blocked by the grating strips. Therefore, at least a part of optical signals can be received, that is, at least a part of light spots can be formed.

At the moment t₁, the grating strips of the grating 1 block a part of optical signals, and therefore, a part of stripe spots can be formed at PD receiving positions of the PD 1, where the light spots are located at a left part of the PD receiving positions of the PD 1. The grating 2 does not block an optical signal, and therefore, complete stripe spots can be formed at receiving positions of the PD 2, where the light spots occupy the PD receiving positions of the PD 2. The grating strips of the grating 3 block a part of optical signals, and therefore, a part of stripe spots can be formed at PD receiving positions of the PD 3, where the light spots are located at a right part of the PD receiving positions of the PD 3. The grating 4 completely blocks an optical signal, and therefore, no stripe spot can be formed at receiving positions of the PD 4.

At the moment t₂, the grating 1 does not block an optical signal (excluding blocking of the optical signal by a left bezel of the grating 1), and therefore, complete stripe spots can be formed at the receiving positions of the PD 1, where the light spots occupy the PD receiving positions of the PD 1. The grating strips of the grating 2 block a part of optical signals, and therefore, a part of stripe spots can be formed at the PD receiving positions of the PD 2, where the light spots are located at a right part of the PD receiving positions of the PD 2. The grating 3 completely blocks an optical signal, and therefore, no stripe spot can be formed at the receiving positions of the PD 3. The grating strips of the grating 4 block a part of optical signals, and therefore, a part of stripe spots can be formed at the PD receiving positions of the PD 4, where the light spots are located at a left part of the PD receiving positions of the PD 4.

At the moment t₃, the grating strips of the grating 1 block a part of optical signals, and therefore, a part of stripe spots can be formed at the PD receiving positions of the PD 1, where the light spots are located at a right part of the PD receiving positions of the PD 1. The grating 2 completely blocks an optical signal, and therefore, no stripe spot can be formed at the receiving positions of the PD 2. The grating strips of the grating 3 block a part of optical signals, and therefore, a part of stripe spots can be formed at the PD receiving positions of the PD 3, where the light spots are located at a left part of the PD receiving positions of the PD 3. The grating 4 does not block an optical signal, and therefore, complete stripe spots can be formed at the receiving positions of the PD 4, where the light spots occupy the PD receiving positions of the PD 4.

At the moment t₄, the grating 1 completely blocks an optical signal, and therefore, no stripe spot can be formed at the receiving positions of the PD 1. The grating strips of the grating 2 block a part of optical signals, and therefore, a part of stripe spots can be formed at the PD receiving positions of the PD 2, where the light spots are located at a left part of the PD receiving positions of the PD 2. The grating 3 does not block an optical signal (excluding blocking of the optical signal by a right bezel of the grating 3), and therefore, complete stripe spots can be formed at the receiving positions of the PD3, where the light spots occupy the PD receiving positions of the PD3. The grating strips of the grating 4 block a part of an optical signal, and therefore, a part of stripe spots can be formed at the PD receiving positions of the PD4, where the light spots are located at a right part of the PD receiving positions of the PD4.

It should be understood that, more complete light spots formed on the PD indicate higher signal light intensity to which the PD responds, and a higher voltage of an output signal. It can be learned from states of the foregoing light spots formed on the surfaces of the PDs that, as the MEMS micromirror rotates periodically, the signal light intensity to which each PD responds also changes periodically, and therefore, a voltage of the output signal of each PD also changes periodically.

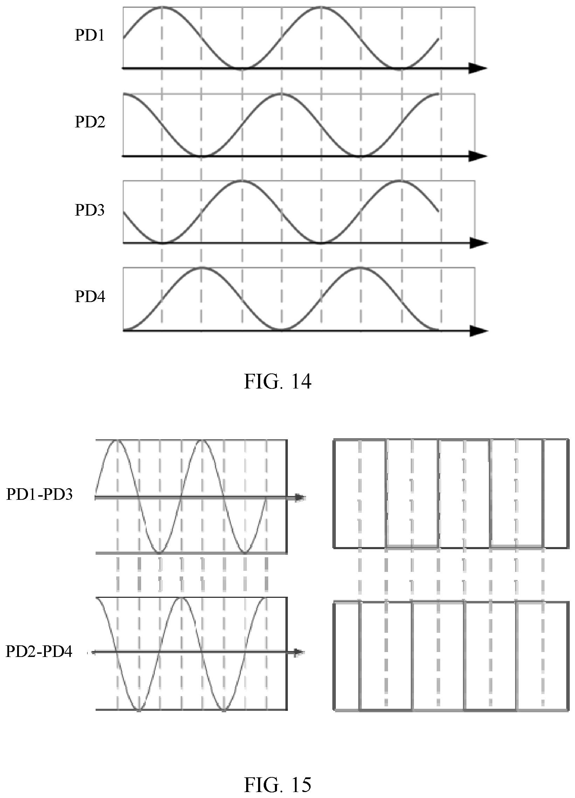

FIG. 14 is a diagram of an output signal of a PD according to an embodiment of this application.

Refer to FIG. 12 and FIG. 13. There is a deviation of a grating strip width d between arranged grating strips of the grating 1 and the grating 3 in the x-axis direction. Therefore, as shown in FIG. 14, a phase difference of π exists between output signal images of the PD 1 and the PD 3. It should be understood that, when a deviation between distribution positions of the grating strips of the grating 1 and the grating 3 is another value, the phase difference between the output signal images of the PD 1 and the PD 3 also changes. The same applies to the PD 2 and the PD 4. In this case, a difference between output signals of the PD 1 and the PD3 is obtained, a difference between output signals of the PD 2 and the PD4 is obtained, and then rotation angles of the MEMS micromirror are calculated based on the output signals whose differences are obtained, so that errors caused by zero-point drift of the apparatus 300 can be eliminated. Because an interval between the PD 1 and the PD 2 is L=(n+(1/2))d, a phase difference between output signals of the PD 1 and the PD 2 is π/2. The same applies to the PD 3 and the PD 4. In this case, after the difference operation is performed on the output signals of the PDs, two sine wave signals PD1-3 and PD2-4 with a phase difference of π/2 can be obtained.

FIG. 15 shows sine wave signals PD1-3 and PD2-4 and square wave signals PD1-3 and PD2-4 according to an embodiment of this application.

The sine wave signal PD1-3 and the sine wave signal PD2-4 may be converted into square wave signals, and then a rotation direction of the MEMS micromirror may be determined by comparing rising edges and falling edges of the square wave signal PD1-3 and the square wave signal PD2-4.

In some possible embodiments, after the sine wave signal PD1-3 and the sine wave signal PD2-4 are obtained, frequency multiplication and subdivision may be performed on the two signals, to improve measurement precision.

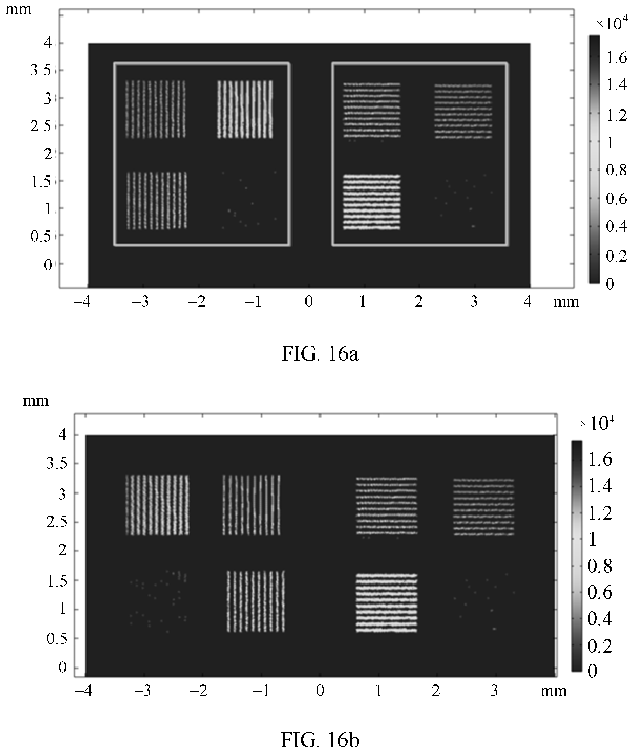

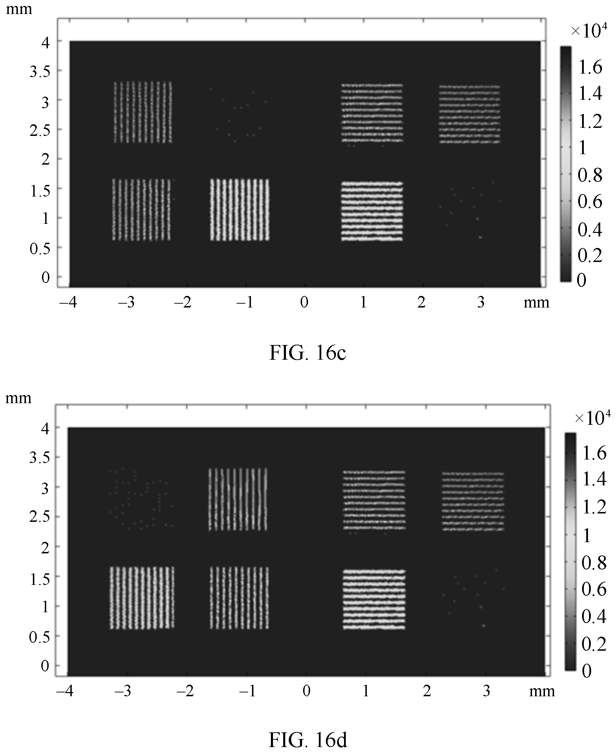

FIG. 16a, FIG. 16b, FIG. 16c, and FIG. 16d are diagrams of simulation experiment results output by the photoelectric detector matrix according to an embodiment of this application.

Simulation experiment is performed based on the grating cover 270 shown in FIG. 9 and the light spots shown in FIG. 11, and a difference between positions of gratings in a same grating array in the grating cover 270 is d/2. The MEMS micromirror performs periodic angular rotation relative to the two axes, and the photoelectric detector matrix 212 receives a reflected laser and outputs a signal. FIG. 15 shows only outputs of an array at an upper right part (denoted as an array 1) and an array at an upper left part (denoted as an array 2) of the photoelectric detector matrix 212.

The output signal of the array 1 is used for measuring an angle at which the MEMS micromirror rotates relative to the x axis, and the output signal of the array 2 is used for measuring an angle at which the MEMS micromirror rotates relative to the y axis. In the array 1 or the array 2, one PD has a strongest output signal, two PDs have medium output signals, and a remaining PD has a weakest output signal, which is almost 0. These conditions respectively correspond to states of light spot intensity received by PDs that are in four PDs within a same grating region and whose positions differ from each other by d/2 at a same moment.

It can be learned based on result diagrams of the output signals of the array 1 and the array 2 at four moments that, signal strength output by each PD in the array 1 does not change, but signal strength output by each PD in the array 2 changes. This means that the MEMS micromirror tilts only relative to the y axis in time periods corresponding to the four moments.

In addition, intensity of light spots on a surface of the array 1 is further measured through simulation experiment.

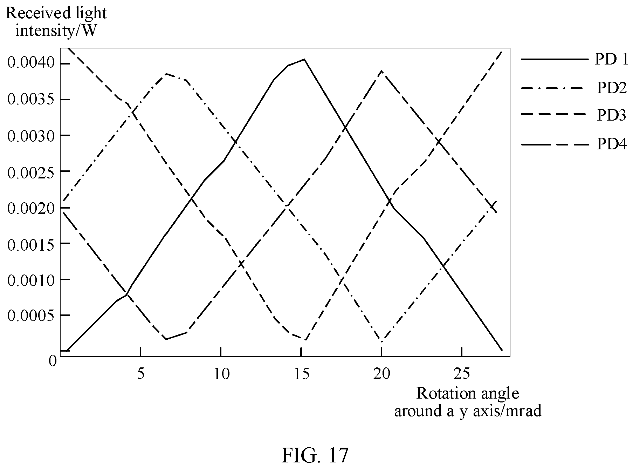

FIG. 17 is a diagram of a simulation experiment result of an intensity change of light spots on a surface of the photoelectric detector matrix according to an embodiment of this application.

Refer to FIG. 17. As the MEMS micromirror rotates, intensity of light spots on surfaces of a PD 1 to a PD 4 in the array 1 also changes, and a phase difference of π/2 successively exists between signals of received light intensity on the surfaces of the PD 1 to the PD 4, which is consistent with the foregoing simulation experiment result.

Considering that output results of the photoelectric detector matrix 212 are correspondingly different when the MEMS micromirror is at different tilt angles, the output result may be an output matrix. For example, if the photoelectric detector matrix 212 includes four PD arrays in a 2×2 arrangement, a corresponding output is a 2×2 output matrix, and an output corresponding to each array element may be a summation result, a weighted average result, or the like of output signals of the four PDs in the array. Output matrices of different results correspond to different tilt angles. Mapping relationships between the output results of the photoelectric detector matrix 212 and the tilt angles of the MEMS micromirror may be calibrated through experiment.

In some possible embodiments, the mapping relationships may also be expressed in a form of a mathematical formula, or may be represented in a form of a mapping table. This is not limited in embodiments of this application.

Based on the foregoing technical solution, a specific design of the grating cover 270 is used, so that a distribution shape of light spots corresponding to an emitted laser corresponds to distribution of the gratings in the grating cover 270, and a phase difference exists in outputs of photoelectric sensors of the photoelectric detector array 2121. Based on the phase difference between the outputs of the photoelectric sensors, a corresponding calculation operation can be performed on an output result of each photoelectric sensor, to eliminate error impact of the angle measurement apparatus 200 caused by temperature drift, and help make an output characteristic of the photoelectric detector matrix 212 more distinct. The tilt angles of the MEMS micromirror can be obtained based on the output characteristic. In addition, because stripe directions of light spots formed on the photoelectric detector matrix 212 correspond to stripe directions of the grating arrays 272, and the light spots also include horizontal-stripe spots (in the first direction) and vertical-stripe spots (in the second direction), as the MEMS micromirror tilts relative to the two axes, distribution of the horizontal-stripe spots changes only when the MEMS micromirror has a deflection amount relative to the slow axis in a deflection process, distribution of the vertical-stripe spots changes only when the MEMS micromirror has a deflection amount relative to the fast axis in the deflection process, thereby helping avoid measurement errors caused by coupling of the MEMS micromirror relative to the two axes, and further improving accuracy of measurement on the tilt angles of the MEMS micromirror.

In addition, an embodiment of this application further provides an angle solving method. The angle solving method includes two parts: determining a calibration parameter; and solving an angle based on the calibration parameter.

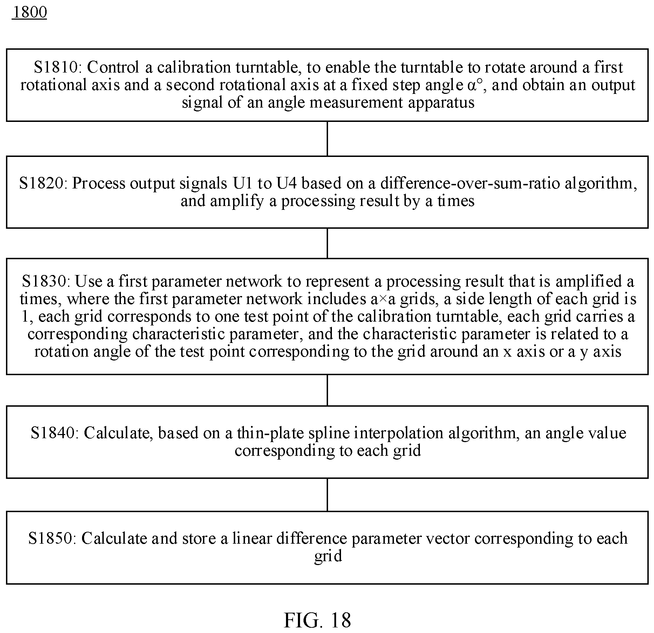

FIG. 18 is a schematic flowchart of a calibration parameter determining method 1800 according to an embodiment of this application. The method is applied to a calibration turntable. Before the following steps are performed, any angle measurement apparatus provided in the foregoing embodiments of this application needs to be mounted on the calibration turntable, and angle measurement is performed on the calibration turntable. The following uses the angle measurement apparatus shown in FIG. 8 as an example for description, where the photoelectric detector is a PD.

It should be understood that a rotation mechanism of the calibration turntable is the same as a rotation mechanism of the MEMS micromirror, that is, rotation relative to a first rotational axis and a second rotational axis is performed. Certainly, in an actual application, the MEMS micromirror may be directly used for replacing the calibration turntable, and the calibration parameter is determined through the following steps and procedure. For ease of description, the first rotational axis is denoted as an x axis, and the second rotational axis is denoted as a y axis in the following.

S1810: Control the calibration turntable, to enable the turntable to rotate around the first rotational axis and the second rotational axis at a fixed step angle α°, and obtain an output signal of the angle measurement apparatus.

For ease of description, an output voltage of 2×2 PDs corresponding to 2×2 gratings (a first grating array) at the upper right of a grating cover is denoted as an output voltage U1 in a first quadrant, an output voltage of 2×2 PDs corresponding to 2×2 gratings (a second grating array) at the upper left of the grating cover is denoted as an output voltage U2 in a second quadrant, an output voltage of 2×2 PDs corresponding to 2×2 gratings (a third grating array) at the lower left of the grating cover is denoted as an output voltage U3 in a third quadrant, and an output voltage of 2×2 PDs corresponding to 2×2 gratings (a fourth grating array) at the lower right of the grating cover is denoted as an output voltage U4 in a fourth quadrant. Outputs U1 to U4 are respectively summation results, weighted average results, or the like output by the PDs in respective arrays.

The output voltages in the four quadrants are recorded at each step angle. A step count is 2m+1, where m is a positive integer. Therefore, values corresponding to U1 to U4 at all step angles may be represented by using a matrix of (2m+1)×(2m+1). At each step angle, rotation angles of the calibration turntable around the x axis are [-mα, -(m-1)α, ..., (m-1)α, mα], where α is the step angle. The same applies to a rotation angle of the calibration turntable around the y axis. An input signal of each PD changes with angles relative to the two axes, and correspondingly, an output signal of each PD also changes.

S1820: Process the output signals U1 to U4 based on a difference-over-sum-ratio algorithm, and amplify a processing result by *a* times, where *a* is an integer greater than 1.

Based on S1820, input signals of a photoelectric detector matrix related to the angles of the calibration turntable and output signals (U1 to U4) of the photoelectric detector matrix can present a monotonic correspondence.

For example, the operation of S1820 may be completed by using the following formula (1). $\begin{matrix}{R}_{x} = a \frac{\left({U}_{1}+{U}_{2}\right) - \left({U}_{3}+{U}_{4}\right)}{{U}_{1} + {U}_{2} + {U}_{3} + {U}_{4}} \\ {R}_{y} = a \frac{\left({U}_{1}+{U}_{4}\right) - \left({U}_{2}+{U}_{3}\right)}{{U}_{1} + {U}_{2} + {U}_{3} + {U}_{4}}\end{matrix}$ (1)

S1830: Use a first parameter network to represent a processing result that is amplified *a* times, where the first parameter network includes *a*×*a* grids, a side length of each grid is 1, each grid corresponds to one test point of the calibration turntable, each grid carries a corresponding characteristic parameter, and the characteristic parameter is related to a rotation angle of the test point corresponding to the grid around the x axis or the y axis.

S1840: Calculate, based on a thin-plate spline interpolation algorithm, an angle value corresponding to each grid.

S1850: Calculate and store a linear difference parameter vector corresponding to each grid.

Using a linear difference parameter of an i^{th} grid as an example, a point at a lower left corner in the i^{th} grid corresponds to a vector ***ai**=*[*aᵢ₀, aᵢ₁, aᵢ₂, aᵢ₃*]*^{T}* and a vector ***bi**=*[*bᵢ₀, bᵢ₁, bᵢ₂, bᵢ₃*]*^{T}.*

It should be understood that rotation angles relative to the two axes and corresponding to each grid can be determined based on the linear difference parameter vector corresponding to each grid. Rotation angles relative to the two axes and corresponding to the point at the lower left corner in the i^{th} grid may be expressed by using the following formula (2), where the i^{th} grid is any grid in the first parameter network. $\left\{\begin{matrix}{T}_{xi} = {a}_{i 0} + {a}_{i 1} {R}_{xi} + {a}_{i 2} {R}_{yi} + {a}_{i 3} {R}_{xi} {R}_{yi} \\ {T}_{yi} = {b}_{i 0} + {b}_{i 1} {R}_{xi} + {b}_{i 2} {R}_{yi} + {b}_{i 3} {R}_{xi} {R}_{yi}\end{matrix}\right.$ (2)

*Rₓᵢ* is a difference-over-sum-ratio corresponding to any point in the i^{th} grid and with respect to the x axis, *R_{yi}* is a difference-over-sum-ratio corresponding to any point in the i^{th} grid and with respect to the y axis, T*ₓᵢ* is a rotation angle about the x axis and corresponding to any point in the i^{th} grid, and *T_{yi}* is a rotation angle about the y axis and corresponding to any point in the i^{th} grid.

Based on the foregoing formula (2), a parameter relationship between the i^{th} grid and an adjacent grid, that is, values of *aᵢ₀, aᵢ₁, aᵢ₂, bᵢ₀, bᵢ₁,* and *bᵢ₂* in the formula (2) that correspond to the i^{th} grid, may be further determined based on a distance d (d=1 in this example) between two adjacent grid center points or corresponding vertices (for example, a point at an upper left corner in the grid, a point at an upper right corner in the grid, a point at a lower left corner in the grid, or a point at a lower right corner in the grid) in the first parameter network. By analogy, values of *aᵢ₀, ail, aᵢ₂, bᵢ₀, bᵢ₁,* and *bᵢ₂* in the formula (2) that correspond to each grid in the first parameter network may be obtained.

In some possible embodiments, linear difference parameter vectors corresponding to all the foregoing grids, that is, ***A=*{*****a₁, a₂**, **a₃**, ...,* ***aₙ*}***,* and ***B*={*b₁*,** ***b₂, b₃,** ...,* ***bₙ*}***,* where n is a quantity of grids, may be stored in a processing chip in the angle measurement apparatus, or stored in a memory connected to the processing chip, or stored in a cloud server that communicates with the angle measurement apparatus in real time, so that the linear difference parameter vectors can be invoked in time when the angle measurement apparatus measures rotation angles of the MEMS micromirror. It should be understood that the linear difference parameter vector is the calibration parameter.

Correspondingly, the angle measurement apparatus may measure a measured target based on the foregoing obtained calibration parameter by using the following method.

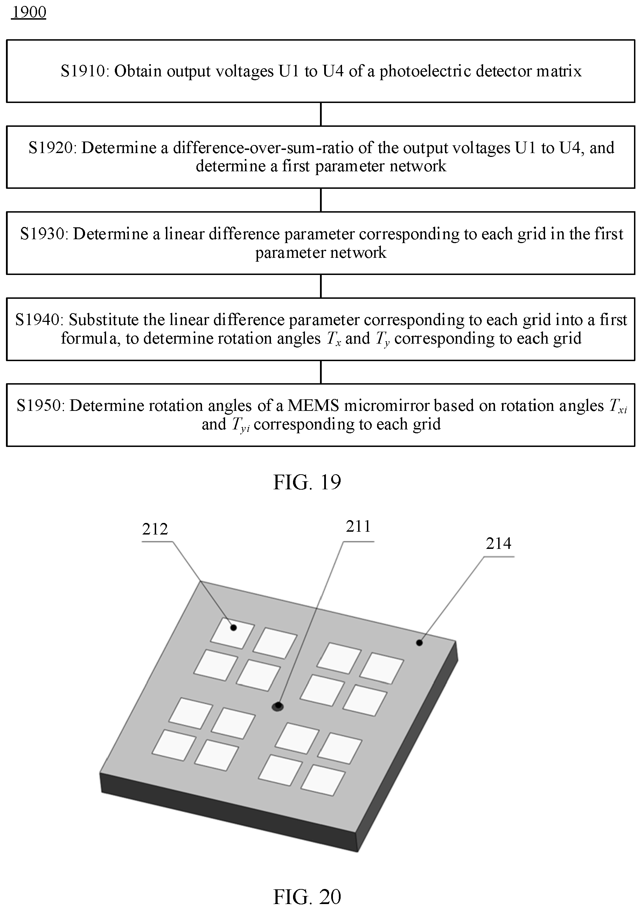

FIG. 19 is a schematic flowchart of a calibration parameter-based angle solving method 1900 according to an embodiment of this application.

The method is described by using the angle measurement apparatus shown in FIG. 8 as an example.

Consistent with the description manner corresponding to FIG. 18, an output voltage of 2×2 PDs corresponding to 2×2 gratings at the upper right of a grating cover is denoted as an output voltage U1 in a first quadrant, an output voltage of 2×2 PDs corresponding to 2×2 gratings at the upper left of the grating cover is denoted as an output voltage U2 in a second quadrant, an output voltage of 2×2 PDs corresponding to 2×2 gratings at the lower left of the grating cover is denoted as an output voltage U3 in a third quadrant, and an output voltage of 2×2 PDs corresponding to 2×2 gratings at the lower right of the grating cover is denoted as an output voltage U4 in a fourth quadrant.

S1910: Obtain the output voltages U1 to U4 of a photoelectric detector matrix.

S1920: Determine a difference-over-sum-ratio of the output voltages U1 to U4, and determine a first parameter network.

The difference-over-sum-ratio of U1 to U4 may be determined by using the foregoing formula (1).

In some possible embodiments, when the difference-over-sum-ratio is not an integer, the difference-over-sum-ratio may be rounded down.

S1930: Determine a linear difference parameter corresponding to each grid in the first parameter network.

In some possible embodiments, a difference-over-sum-ratio corresponding to a point at a lower left corner of an i^{th} grid is denoted as (*Rₓᵢ, R_{yi}*)*,* a difference-over-sum-ratio corresponding to a point at an upper left corner of the i^{th} grid is denoted as (*Rₓᵢ, R_{y(i+1)}*)*,* a difference-over-sum-ratio corresponding to a point at a lower right corner of the i^{th} grid is denoted as (*Rₓ₍ᵢ₊₁₎*, *R_{yi}*), and a difference-over-sum-ratio corresponding to a point at an upper right corner of the i^{th} grid is denoted as (*Rₓ₍ᵢ₊₁₎*, *R_{y(i+1)}*). A linear difference parameter vector corresponding to the i^{th} grid can be obtained based on the difference-over-sum-ratios corresponding to the four corners, and similarly, a linear difference parameter corresponding to each grid can be determined.

S1940: Substitute the linear difference parameter corresponding to each grid into a first formula, to determine rotation angles *Tₓ* and *T_{y}* corresponding to each grid.

The first formula is the foregoing formula (2).

S1950: Determine rotation angles of a MEMS micromirror based on rotation angles *Tₓᵢ* and *T_{yi}* corresponding to each grid.

In some possible embodiments, the foregoing method 1900 may be performed by using a microcontroller unit (microcontroller unit, MCU).

Based on the foregoing technical solution, a mathematical formula used for angle resolution can be determined through experiment, and the mathematical formula can be directly applied to the angle measurement apparatus 300, so that the angle measurement apparatus 300 can directly determine the rotation angles of the MEMS micromirror based on outputs of the photoelectric detector matrix. In addition, because the method is proposed based on a dual-axis decoupled detection structure that is specific to the angle measurement apparatus 300, the method can not only eliminate errors of the angle measurement apparatus caused by temperature drift, but also help reduce angle measurement errors caused by decoupling of the two axes.

FIG. 20 is a diagram of an integrated angle measurement apparatus according to an embodiment of this application.

Refer to FIG. 20. On the apparatus 200 or the apparatus 300, a photoelectric detector matrix 212 and a light source 211 may be fabricated on a same silicon chip through a process such as epitaxial growth and doping.

It should be understood that the apparatus 200 or the apparatus 300 may be fabricated through a semiconductor preparation technology. Therefore, a photoelectric detector does not need to be directly mounted on a silicon substrate. In a process of directly mounting the photoelectric detector on the silicon substrate, a large mounting error easily exists. However, when the photoelectric detector is fabricated on the silicon chip based on the semiconductor preparation technology, position errors between photoelectric detectors can be effectively reduced based on a characteristic of high precision of the technology.

Based on the foregoing technical solution, the light source 211 and the photoelectric detector matrix are integrated on the silicon chip, that is, the silicon chip is equivalent to the foregoing silicon substrate 214, to measure tilt angles of a MEMS micromirror without an additional packaging step, thereby effectively reducing packaging costs of the angle measurement apparatus 20. In addition, based on the photoelectric detector matrix obtained through integrated production, response capabilities of the photoelectric detectors to light are also consistent, thereby helping avoid errors caused by a difference between the response capabilities of the photoelectric detectors.

It should be noted that a deployment position of the apparatus 300 is similar to a deployment position of the apparatus 200. For specific extended descriptions, refer to the foregoing corresponding embodiments. Details are not described herein again.

Based on the angle measurement apparatus 200 and the apparatus 300 provided in the foregoing embodiments, an embodiment of this application further provides a lidar scanning system.

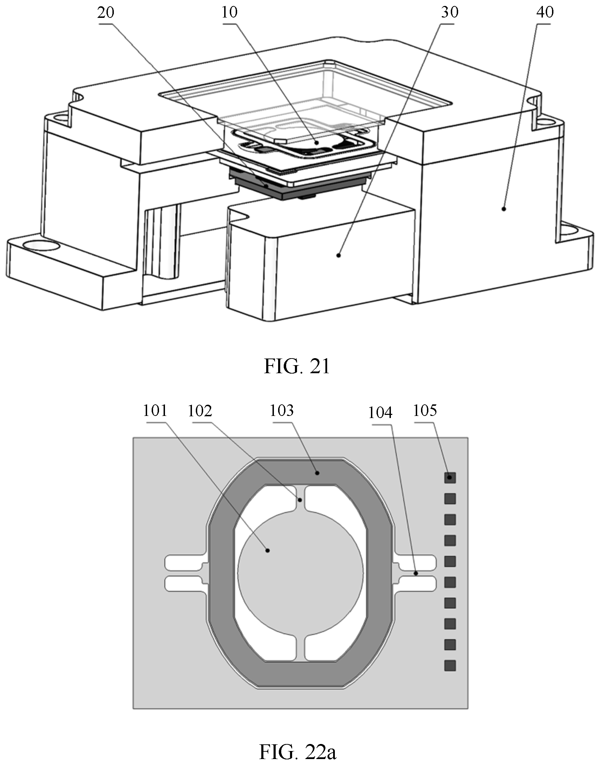

FIG. 21 is a diagram of a lidar scanning system 2100 according to an embodiment of this application.

The system 2100 includes:
a MEMS micromirror apparatus 10, including a MEMS micromirror 108, a first rotational axis, and a second rotational axis, where the MEMS micromirror 108 tilts relative to the first rotational axis and the second rotational axis; and
an angle measurement apparatus 20, disposed below the MEMS micromirror apparatus 10 and facing a first surface of the MEMS micromirror 108, where the angle measurement apparatus 20 includes a light source 211 and a photoelectric detector matrix 212, the photoelectric detector matrix 212 includes N photoelectric detector arrays 2121, the photoelectric detector matrix 212 and the light source 211 are located on a same plane, N is greater than or equal to 4, and the light source 211 is located at a central position of the photoelectric detector matrix 212.

In some possible embodiments, the photoelectric detector array 2121 includes four photoelectric detectors in a 2×2 arrangement, and the N photoelectric detector arrays 2121 are separately located around the light source 211.

In some possible embodiments, the light source 211 is configured to emit a light beam to the first surface of the MEMS micromirror 108, the first surface of the MEMS micromirror is coated with a reflective layer, and the MEMS micromirror is configured to reflect the light beam to the photoelectric detector matrix.

In some possible embodiments, the light source 211 and the photoelectric detector matrix 212 are located on a same silicon substrate 214.

In some possible embodiments, the angle measurement apparatus 20 further includes a grating cover 270. The grating cover 270 includes N grating arrays 272. The grating cover 270 is disposed on the photoelectric detector matrix 212. Positions of the N grating arrays 272 are in one-to-one correspondence with positions of the N photoelectric detector arrays 2121. A stripe direction of a first part of gratings in the N grating arrays 272 is a first direction, a stripe direction of a second part of gratings in the N grating arrays 272 is a second direction, the first direction is parallel to the first rotational axis of the MEMS micromirror, and the second direction is parallel to the second rotational axis of the MEMS micromirror.

In some possible embodiments, the grating cover 270 further includes a lens 271. A position of the lens 271 corresponds to a position of the light source 211. The lens 271 is configured to enable distribution of light spots formed by the light beam emitted by the light source 211 to correspond to stripe directions and stripe shapes of the N grating arrays 272 in the grating cover 270.

In some possible embodiments, a first spacing exists between a first grating in the first part of gratings and a second grating adjacent to the first grating in the second direction, a stripe of the first grating and a stripe of a third grating adjacent to the first grating in the first direction are staggered by a second spacing in the second direction, the first spacing exists between a fourth grating in the second part of gratings and a fifth grating adjacent to the fourth grating in the first direction, a stripe of the fourth grating and a stripe of a sixth grating adjacent to the fourth grating in the second direction are staggered by the second spacing in the first direction, the first spacing is (n+(1/4))d or (n+(1/2))d, the second spacing is m×d, n and m are integers, and d is a stripe width of the grating.

In some possible embodiments, a light shielding portion is provided on a side surface of the lens 271, and the light shielding portion is configured to shield interference light incident from the side surface of the lens 271.

In some possible embodiments, the light source is a VCSEL or an LED, and the photoelectric detector is a PD.

It should be understood that the angle measurement apparatus 20 is consistent with the apparatus 200 or the apparatus 300 in the foregoing embodiments. For related descriptions of angle measurement by the angle measurement apparatus 20, refer to the foregoing corresponding descriptions of the apparatus 200 or the apparatus 300. Details are not described herein again. Similarly, for a diagram of a structure of the angle measurement apparatus 20, refer to a corresponding diagram of a structure of the foregoing apparatus 200 or apparatus 300.

For example, the first rotational axis may be a fast axis of the MEMS micromirror, and the second rotational axis may be a slow axis of the MEMS micromirror.

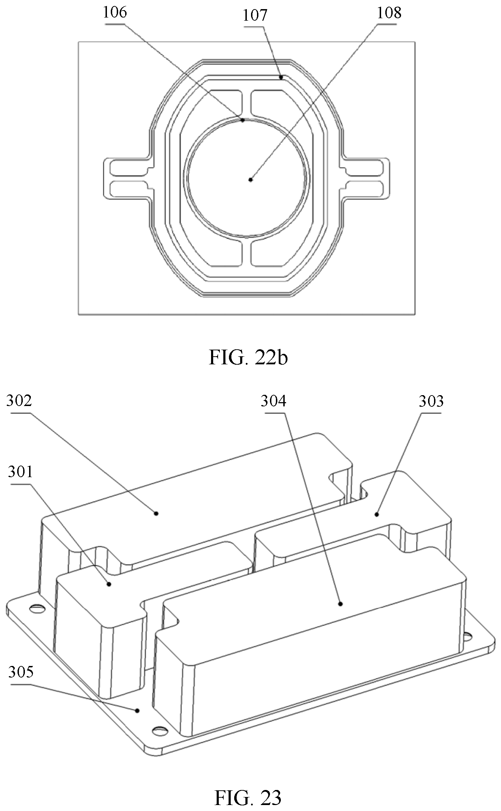

FIG. 22a and FIG. 22b are diagrams of a MEMS micromirror apparatus 10 according to an embodiment of this application.

FIG. 22a shows a front structure of the MEMS micromirror apparatus 10. The MEMS micromirror apparatus 10 further includes a substrate 101, a driving coil 103, a first rotational axis support beam 102, a second rotational axis support beam 104, and a pad 105.

The MEMS micromirror 108 is connected to the driving coil 103 through a first rotational axis.

The driving coil 103 includes a coil frame and a coil made according to a MEMS manufacturing process standard. The coil frame is connected to the substrate 101 through a second rotational axis, and the first rotational axis and the second rotational axis are perpendicular to each other, so that the MEMS micromirror 108 can deflect in a horizontal direction and a vertical direction.

The pad 105 is configured to electrically connect the MEMS micromirror 108 to an external circuit.

In some possible embodiments, the driving coil 103 may be a planar coil or a stacked coil fabricated through deposition, electroplating, or another method.

FIG. 22b shows a rear structure of the MEMS micromirror apparatus 10.

In some possible embodiments, a first surface of the MEMS micromirror 108 is coated with a reflective film, and the first surface faces an angle measurement apparatus 20. It should be understood that the first surface may be a bottom surface (also referred to as a back side) of the MEMS micromirror 108 described in the foregoing embodiment.

In some possible embodiments, the MEMS micromirror apparatus 10 further includes a first support frame 106 and a second support frame 107. The first support frame 106 is disposed on the bottom surface (also referred to as the back side) of the MEMS micromirror 108, and the second support frame 107 is disposed on a bottom surface (also referred to as a back side) of the coil frame of the driving coil 103, to avoid large deformation of the MEMS micromirror 108 and the coil frame of the driving coil 103 in a manufacturing process or an operation process.

Based on the foregoing technical solution, the lidar scanning system can accurately measure tilt angles of the MEMS micromirror, and can not only eliminate errors caused by temperature drift of the apparatus, but also avoid measurement errors caused by biaxial coupling of the MEMS micromirror, so that the lidar scanning system can accurately measure the tilt angles of the MEMS micromirror, thereby ensuring accuracy of real-time control on rotation angles of the MEMS micromirror.

In some possible embodiments, the system 2100 further includes:
a drive apparatus 30, disposed below the angle measurement apparatus 20, where the drive apparatus 30 is configured to drive the MEMS micromirror 108 to tilt relative to the first rotational axis and the second rotational axis; and
a support apparatus 40, configured to support the MEMS micromirror apparatus 10, the angle measurement apparatus 20, and the drive apparatus 30.

FIG. 23 is a diagram of a structure of a drive apparatus 30 according to an embodiment of this application.

Refer to FIG. 23. The drive apparatus 30 includes a plurality of permanent magnets and a bottom plate 305, where the plurality of permanent magnets are fastened onto the bottom plate 305. For example, the drive apparatus 30 may include four permanent magnets (301, 302, 303, and 304), and the bottom plate 305 may be an iron sheet.

In addition, an embodiment of this application further provides a vehicle. The vehicle includes any lidar scanning system provided in the foregoing embodiments, or a lidar scanning system of the vehicle includes any angle measurement apparatus provided in the foregoing embodiments.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located at one position, or may be distributed on a plurality of network units. A part or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or a part of the technical solutions may be implemented in a form of a software product. The computer software product is stored in a storage medium, and includes several instructions for indicating a computer device (which may be a personal computer, a server, or a network device) to perform all or a part of the steps of the methods described in embodiments of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An angle measurement apparatus, configured to measure tilt angles of a micro-electro-mechanical system MEMS micromirror relative to a first rotational axis and a second rotational axis, wherein the apparatus comprises:
a light source; and
a photoelectric detector matrix, comprising N photoelectric detector arrays, wherein the photoelectric detector matrix and the light source are located on a same plane, N is greater than or equal to 4, and the light source is located at a central position of the photoelectric detector matrix.

2. The apparatus according to claim 1, wherein the photoelectric detector array comprises four photoelectric detectors in a 2×2 arrangement, and the N photoelectric detector arrays are separately located around the light source.

3. The apparatus according to claim 1 or 2, wherein the light source is configured to emit a light beam to a first surface of the MEMS micromirror, the first surface of the MEMS micromirror is coated with a reflective layer, and the MEMS micromirror is configured to reflect the light beam to the photoelectric detector matrix.

4. The apparatus according to any one of claims 1 to 3, wherein the light source and the photoelectric detector matrix are located on a same silicon substrate.

5. The apparatus according to any one of claims 1 to 4, wherein the apparatus further comprises a grating cover, the grating cover comprises N grating arrays, the grating cover is disposed on the photoelectric detector matrix, positions of the N grating arrays are in one-to-one correspondence with positions of the N photoelectric detector arrays, a stripe direction of a first part of gratings in the N grating arrays is a first direction, a stripe direction of a second part of gratings in the N grating arrays is a second direction, the first direction is parallel to the first rotational axis of the MEMS micromirror, and the second direction is parallel to the second rotational axis of the MEMS micromirror.

6. The apparatus according to claim 5, wherein the grating cover further comprises a lens, a position of the lens corresponds to a position of the light source, and the lens is configured to enable distribution of light spots formed by the light beam emitted by the light source to correspond to stripe directions and stripe shapes of the N grating arrays in the grating cover.

7. The apparatus according to claim 5 or 6, wherein a first spacing exists between a first grating in the first part of gratings and a second grating adjacent to the first grating in the second direction, a stripe of the first grating and a stripe of a third grating adjacent to the first grating in the first direction are staggered by a second spacing in the second direction, the first spacing exists between a fourth grating in the second part of gratings and a fifth grating adjacent to the fourth grating in the first direction, a stripe of the fourth grating and a stripe of a sixth grating adjacent to the fourth grating in the second direction are staggered by the second spacing in the first direction, the first spacing is (n+(1/4))d or (n+(1/2))d, the second spacing is m×d, n and m are integers, and d is a stripe width of the grating.

8. The apparatus according to claim 6 or 7, wherein a light shielding portion is provided on a side surface of the lens, and the light shielding portion is configured to shield interference light incident from the side surface of the lens.

9. The apparatus according to any one of claims 1 to 8, wherein the photoelectric detector matrix is configured to: collect light beams reflected by the MEMS micromirror; and output N collection results, wherein mapping relationships exist between the N collection results and the tilt angles of the MEMS micromirror.

10. The apparatus according to any one of claims 1 to 9, wherein the light source is a vertical cavity surface emitting laser VCSEL or a light emitting diode LED, and the photoelectric detector is a photo diode PD.

11. A lidar scanning system, comprising:
a micro-electro-mechanical system MEMS micromirror apparatus, comprising a MEMS micromirror, a first rotational axis, and a second rotational axis, wherein the MEMS micromirror tilts relative to the first rotational axis and the second rotational axis; and
the angle measurement apparatus according to any one of claims 1 to 10, wherein the angle measurement apparatus is disposed below the MEMS micromirror apparatus, and faces a first surface of the MEMS micromirror.

12. The system according to claim 11, wherein the system further comprises:
a drive apparatus, disposed below the angle measurement apparatus, wherein the drive apparatus is configured to drive the MEMS micromirror to tilt relative to the first rotational axis and the second rotational axis; and
a support apparatus, configured to support the MEMS micromirror apparatus, the angle measurement apparatus, and the drive apparatus.

13. A vehicle, wherein the vehicle comprises the lidar scanning system according to claim 11 or 12, or the lidar scanning system of the vehicle is equipped with the angle measurement apparatus according to any one of claims 1 to 10.
